(19) Europäisches Patentamt
European Patent Office
Office européen des brevets

(11) **EP 1 462 810 B1**

(12) **EUROPÄISCHE PATENTSCHRIFT**

(45) Veröffentlichungstag und Bekanntmachung des Hinweises auf die Patenterteilung:
**09.09.2015 Patentblatt 2015/37**

(51) Int Cl.:
***G01R 15/24*** (2006.01)    ***G01R 19/00*** (2006.01)

(21) Anmeldenummer: **03405213.4**

(22) Anmeldetag: **28.03.2003**

(54) **Temperaturkompensierter elektrooptischer Spannungssensor**

Temperature compensated electro-optical voltage sensor

Capteur de tension électrooptique compensée en température

(84) Benannte Vertragsstaaten:
**AT BE BG CH CY CZ DE DK EE ES FI FR GB GR HU IE IT LI LU MC NL PT RO SE SI SK TR**

(43) Veröffentlichungstag der Anmeldung:
**29.09.2004 Patentblatt 2004/40**

(73) Patentinhaber: **ABB Research Ltd.**
**8050 Zürich (CH)**

(72) Erfinder:
• **Bohnert, Klaus**
  **5452 Oberrohrdorf (CH)**
• **Frank, Andreas**
  **8037 Zürich (CH)**
• **Brändle, Hubert**
  **8102 Oberengstringen (CH)**

(74) Vertreter: **ABB Patent Attorneys**
**c/o ABB Schweiz AG**
**Intellectual Property CH-IP**
**Brown Boveri Strasse 6**
**5400 Baden (CH)**

(56) Entgegenhaltungen:
EP-A- 0 997 738        EP-A2- 0 682 261
DE-A- 19 716 477        US-A- 4 269 483
US-A- 4 465 969         US-A- 4 563 093
US-A1- 2003 034 768     US-B1- 6 307 666

**Beschreibung**

**Technisches Gebiet**

Die Erfindung bezieht sich auf das Gebiet der elektrooptischen Spannungssensorik, insbesondere der Hochspannungsmessung. Sie bezieht sich auf einen elektrooptischen Spannungssensor gemäss dem Oberbegriff des Patentanspruches 1 und auf ein Verfahren zur elektrooptischen Spannungsmessung gemäss dem Oberbegriff des Patentanspruches 11.

**Stand der Technik**

Eine derartiger Spannungssensor und ein entsprechendes Verfahren ist beispielsweise aus EP 0 682 261 A2 bekannt. An zwei Enden eines elektrooptischen Kristalls wird eine zu messende elektrische Spannung V angelegt. Linearpolarisiertes Licht wird in den Kristall eingestrahlt und breitet sich darin in Form von zwei zueinander orthogonal polarisierten Lichtwellen aus. Das Licht wird nach Durchlaufen des Kristalls detektiert. Durch den Pockels-Effekt wird eine spannungsabhängige Doppelbrechung im Kristall induziert, so dass eine zu der zu messenden elektrischen Spannung V proportionale Polarisationsänderung des aus dem Kristall ausgetretenen Lichtes nachweisbar ist, beispielsweise in Form einer Intensitätsmodulation des Lichtes.

Der für den Pockels-Effekt massgebliche elektrooptische Koeffizient weist zumeist eine Temperaturabhängigkeit auf. Für einen BGO-Kristall ($Bi_4Ge_3O_{12}$) beispielsweise beträgt diese Temperaturabhängigkeit $1.54 \times 10^{-4}$ / °C (P.A. Williams et al, Applied Optics 35, 3562-3569, 1996). In der genannten EP 0 682 261 A2 wird die aus der gemessenen Polarisationsänderung bestimmte Spannung rechnerisch für Temperatureffekte korrigiert, wobei zur Bestimmung der Temperatur des elektrooptischen Kristalls eine bekannte Temperaturabhängigkeit eines im Lichtweg befindlichen und nahe dem elektrooptischen Kristalls angeordneten $\lambda/4$-Plättchens ausgenutzt wird.

Ein derartiger Spannungssensor hat den Nachteil, dass für die rechnerische Temperaturkompensation verschiedene Näherungsannahmen gemacht werden müssen und dass die gemessene Temperatur nicht notwendigerweise der Temperatur des elektrooptischen Kristalls entspricht. Eine solche Temperaturkompensation ist also einerseits rechenaufwendig und andererseits nicht sehr genau.

US 4,269,483 offenbart einen temperaturkompensierten elektrooptischen Spannungssensor miet einem elektrooptisch aktiven Kristall und einem ebenfalls elektrooptisch aktiven Kompensationskristall wobei der Temperaturgang des elektroptischen Koeffizienten des elektrooptisch aktiven Kristalls kompensiert wird.

US 6,307,666 offenbart einen temperaturkompensierten elektrooptischen Spannungssensor mit einem elektrooptisch aktiven Kristall und einem Kompensationskristall, wobei mit letzterem Kristall die vorliegende Temperaturabhängigkeit der Brechungsindizes bei natürlicher Doppelbrechung kompensiert wird. Dazu wird vorgeschlagen, als Kompensationskristall einen zum elektrooptisch aktiven Kristall äquivalenten Kristall zu verwenden, der 90' um die Achse der Lichtausbreitung rotiert wird und zudem vollständig vom elektrischen Feld abgeschirmt wird.

DE 197 16 477 A1 offenbart eine Temperaturkompensation für einen elektrooptischen Spannungssensor mit einem oder mehreren elektrooptischen Kristallen. Dazu wird der Lichtstrahl nach Verlassen des elektrooptisch aktiven Kristalls in zwei Strahlen aufgespalten und ein Teilstrahl durch ein temperaturabhängiges optisch aktives Element geschickt. Der Vergleich der zwei Teilstrahlen ermöglicht es auf die Temperatur zu schliessen und somit die gemessene Spannung um den Temperatureffekt zu korrigieren.

**Darstellung der Erfindung**

Es ist deshalb Aufgabe der Erfindung, einen elektrooptischen Spannungssensor und ein entsprechendes Messverfahren der eingangs genannten Art zu schaffen, welche die oben genannten Nachteile nicht aufweisen. Insbesondere soll eine einfache und genaue Temperaturkompensation ermöglicht werden. In einem vorgebbaren Temperaturbereich soll die mittels des Sensors bestimmte Spannung im wesentlichen unabhängig von der Temperatur sein.

Diese Aufgabe löst ein elektrooptisch Spannungssensor mit den Merkmalen des Patentanspruches 1 und ein Verfahren mit den Merkmalen des Patentanspruches 11.

In dem erfindungsgemässen Spannungssensor sind zwischen den zwei Elektroden, an denen die zu messende Spannung V anliegt, mindestens zwei Medien angeordnet, von denen mindestens eines ein elektrooptisch aktives Medium ist, wobei die effektiven Dicken der Medien derart gewählt sind, dass das Spannungssignal des Sensors im wesentlichen nicht von der Temperatur abhängig ist. Durch die Wahl der Dicken der Medien und der Art der Medien kann eine gegenseitige Aufhebung verschiedener Temperatureinflüsse auf die mittels des Sensors bestimmte Spannung (Spannungssignal des Sensors) erzielt werden.

Der erfindungsgemässe Sensor ist ein elektrooptischer Spannungssensor zur Messung einer elektrischen Spannung V, wobei die Spannung V zwischen zwei Elektroden anliegt und ein elektrisches Feld erzeugt, wobei die Elektroden voneinander beabstandet angeordnet sind, und wobei zwischen den Elektroden ein elektrooptisch aktives Medium angeordnet ist, in welches Licht einstrahlbar ist, dessen Polarisationszustand in dem elektrooptisch aktiven Medium durch das elektrische Feld beeinflussbar und nach Austritt aus dem elektrooptisch aktiven Medium detektierbar ist, wobei aus dem detektierten Polarisationszustand die Spannung V bestimmbar ist.

Er kennzeichnet sich dadurch, dass zwischen den zwei Elektroden ein Abstandsmedium angeordnet ist, wobei das elektrooptisch aktive Medium mit einer effektiven Dicke $d_1$ und das Abstandsmedium mit effektiven Dicke $d_2$ zwischen den zwei Elektroden angeordnet ist, und wobei die effektiven Dicken $d_1, d_2$ derart gewählt sind, dass Einflüsse der Temperatur auf den detektierten Polarisationszustand des Lichtes im wesentlichen kompensiert sind. Die zwei Medien sind zwischen den Elektroden im wesentlichen hintereinander angeordnet. Die Hintereinanderanordnung der Medien 1,2 schliesst selbstverständlich nicht aus, dass die Medien 1,2 in Form mehrerer Elemente angeordnet sein können, welche zumindest zum Teil hintereinander zwischen den Elektroden 3,4 angeordnet sind. Die effektiven Dicken der Medien können von der Lichtführung abhängen. Da bei typischen Materialien der Einfluss der thermischen Ausdehnungskoeffizienten ($\alpha$) auf die Temperaturabhängigkeit des Spannungssignals des Sensors um eine halbe oder eine ganze Grössenordnung kleiner ist als der Einfluss der Temperaturabhängigkeit der Dielektrizitätskonstanten ($\varepsilon$) und insbesondere des massgeblichen elektrooptischen Koeffizienten (k), kann bereits dadurch eine gute Temperaturkompensation erreicht werden, dass nur die Dielektrizitätskonstanten ($\varepsilon$) und die massgeblichen elektrooptischen Koeffizienten (k) berücksichtigt werden. Falls das Abstandsmedium nicht elektrooptisch aktiv ist oder nicht durchstrahlt wird, brauchen nur $\varepsilon_1$, $\varepsilon_2$ und $k_1$ berücksichtigt zu werden, wobei der Index 1 für das elektrooptisch aktive Medium und der Index 2 für das Abstandsmedium stehen. Die Einflüsse der Temperaturabhängigkeiten der jeweiligen Grössen auf das Spannungssignal (oder auf den detektierten Polarisationszustand des Lichtes) heben einander gegenseitig im wesentlichen auf.

Dadurch wird es möglich, eine temperaturunabhängige Spannungsmessung zu erreichen. Die Temperaturkompensation ist intrinsisch, so dass es keiner separaten Temperaturmessung und/oder rechnerischen Temperaturkompensation bedarf. Ausserdem ist es möglich, auch bei hohen Spannungen V noch eindeutige Messergebnisse zu erhalten. Weiterhin erlaubt die Anordnung eines elektrooptisch aktiven Mediums und eines Abstandsmediums zwischen den Elektroden die Realisierung relativ grosser Elektrodenabstände, so dass eine geringe Empfindlichkeit gegen äussere Störungen des elektrischen Feldes und relativ geringe Durchmesser einer den Sensor umgebenden Isolation möglich werden.

Vorzugsweise sind die effektive Dicke $d_2$ des Abstandsmediums und die effektive Dicke d, des elektrooptisch aktiven Mediums derart gewählt, dass sich die Einflüsse der Temperaturabhängigkeiten von temperaturabhängigen Materialkonstanten des Abstandsmediums und des elektrooptisch aktiven. Mediums auf den detektierten Polarisationszustand des Lichtes im wesentlichen kompensieren.

Insbesondere sind in der Praxis die Materialkonstanten

- massgeblicher elektrooptischer Koeffizient (k),
- Dielektrizitätskonstante ($\varepsilon$) und
- thermischer Ausdehnungskoeffizient ($\alpha$)

wichtig und zumeist temperaturabhängig.

In einer vorteilhaften Ausführungsform ist das Abstandsmedium transparent und von festem Aggregatzustand. Vorteilhaft werden das elektrooptisch aktive Medium und auch das Abstandsmedium von dem Licht, dessen Polarisationszustand durch das elektrische Feld verändert wird, durchstrahlt. Dadurch kann ein mechanisch und optisch stabiler Aufbau erreicht werden. Die Wahl des Abstandsmediums kann derart erfolgen, dass Brechnungsindexunterschiede an Grenzflächen zwischen Abstandsmedium und elektrooptisch aktiven Mediums gering sind, so dass Reflexionsverluste minimal sind. Dadurch können Lichtverluste an Grenzflächen minimiert werden, so dass man bei geringer Lichtleistung messen kann.

Zwischen den Elektroden ist ein Stapel von N Elementen des elektrooptisch aktiven Mediums und (N+1) Elementen des Abstandsmediums angeordnet, wobei N eine ganze Zahl mit $N \geq 1$, vorteilhaft $N \geq 2$, ist. Jeweils ein Element des elektrooptisch aktiven Mediums ist zwischen zwei benachbarten Elementen des Abstandsmediums angeordnet, wobei das erste und das letzte Element in dem Stapel mit je einer der zwei Elektroden in Kontakt ist. Dadurch erhält man eine genaue Approximation an die zu messende Spannung V mit wenig Reflexionsverlusten und mit grosser mechanischer Stabilität. Besonders vorteilhaft ist jedes der Elemente im wesentlichen zylinderförmig, wobei alle Elemente im wesentlichen denselben Zylinderdurchmesser aufweisen. Vorteilhaft bilden die zwischen den Elektroden angeordneten Medien einen Sensorstab.

Eine weitere vorteilhafte Ausführungsform kennzeichnet sich dadurch, dass die Elemente des elektrooptisch aktiven Mediums eine solche effektive Dicke aufweisen und derart zwischen den Elektroden angeordnet sind, dass eine Abweichung des Spannungssignals des Sensors, also der mittels des Spannungssensors bestimmten Spannung, von der zu messenden Spannung V minimal ist. Eine solche Anordnung ist beispielsweise mittels Näherungsrechnungen oder Simulationen bestimmbar. Es können besonders genaue Messungen und eine grosse Unempfindlichkeit gegen äussere Störungen des elektrischen Feldes, beispielsweise aufgrund von Regen oder Schnee in Sensornähe, und gegen Querfelder, beispielsweise aufgrund von benachbarten elektrischen Phasen nahe dem Sensor, erzielt werden.

Besonders vorteilhaft können die Elektroden mitsamt dem elektrooptisch aktiven Medium und dem Abstandsmedium in Silikon eingegossen werden. Vorteilhaft weist das Silikon eine Schichtdicke auf, die so gross ist, dass bei anliegenden Blitzstoss-Spannungen (gemäss IEC-Norm 186, IEC = International Electrotechnical Commission, Geneva, Switzerland) eine elektrische Feldstärke aussen am Silikon maximal 40 kV/mm, und insbesondere maximal 30 kV/mm beträgt. Blitzstoss-Spannungen etwa das drei- bis fünffache der Betriebsspannung, für die der Sensor ausgelegt ist. Für eine Betriebsspannung von 170 kV beträgt die Blitzstoss-Spannung, die der Sensor noch aushalten muss, 750 kV (Scheitelwert); für eine Betriebsspannung von 245 kV beträgt die Blitzstoss-Spannung 1050 kV; für eine Betriebsspannung von 420 kV beträgt die Blitzstoss-Spannung 1425 kV (gemäss IEC-Norm 186).

Durch die Silikonummantelung ist ein Sensor mit sehr geringen Abmessungen und geringem Gewicht herstellbar, der trotzdem über eine ausreichende elektrische Isolation verfügt. Teure, grosse, schwere Isolationsrohre, typischerweise aus glasfaserverstärktem Kunststoff, können vermieden werden. Das geringe Gewicht und die kleinen Abmessungen ermöglichen einen Einsatz des Sensors an Stellen oder in Lagen, an oder in denen konventionell isolierte Sensoren nicht einsetzbar sind. Beispielsweise hängend an einem hochspannungsführenden Anlagenteil.

Eine besonders vorteilhafte Ausführungsform kennzeichnet sich dadurch, dass das elektrooptisch aktive Medium kristallines BGO (Wismut-Germanium-Oxid, $Bi_4Ge_3O_{12}$) ist, das mit seiner [001]-Richtung parallel zur Ausbreitungsrichtung des Lichtes orientiert ist, und dass die Ausbreitungsrichtung des Lichtes im wesentlichen entlang des von der Spannung V erzeugten elektrischen Feldes verläuft, und dass das Abstandsmedium Quarzglas ist. Dadurch ist ein besonders gut temperaturstabilisierter Sensor realisierbar, der ausserdem eine grosse Unempfindlichkeit gegen äussere Störungen der Feldverteilung ist. Insbesondere ist es damit sehr gut möglich, an einem Pol eines Hochspannungsnetzes Messungen vorzunehmen ohne dass eine weiterer, in der Nähe befindlicher Pol, die Messung beeinflusst.

Das erfindungsgemässe Verfahren zur Messung einer elektrischen Spannung V, wobei die Spannung V zwischen zwei voneinander beabstandet angeordneten Elektroden anliegt und ein elektrisches Feld erzeugt, wobei Licht in ein zwischen den Elektroden angeordnetes elektrooptisch aktives Medium eingestrahlt wird, und wobei ein Polarisations-zustand des Lichtes in dem elektrooptisch aktiven Medium durch das elektrische Feld beeinflusst wird und das Licht nach Austritt aus dem elektrooptisch aktiven Medium detektiert wird und aus dem detektierten Polarisationszustand die Spannung V bestimmt wird, kennzeichnet sich dadurch, dass zwischen den zwei Elektroden ein Abstandsmedium angeordnet wird, wobei eine effektive Dicke $d_2$ des Abstandsmediums und eine effektive Dicke $d_1$ des elektrooptisch aktiven Mediums derart gewählt wird, dass Einflüsse der Temperatur auf den detektierten Polarisationszustand des Lichtes im wesentlichen kompensiert werden.

Weitere bevorzugte Ausführungsformen und Vorteile gehen aus den abhängigen Patentansprüchen und den Figuren hervor.

Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:

Fig. 1    einen erfindungsgemässen Sensor in Transmissionsgeometrie, schematisch;
Fig. 2    eine berechnete Kurve, die die Abhängigkeit der relativen Änderung der elektrischen Feldstärke in BGO in einem BGO-Quarzglas-Stapel mit der Temperatur von der effektiven Dicke $d_1$ des elektrooptisch aktiven Mediums BGO veranschaulicht;
Fig. 3    eine berechnete Kurve, die die Halbwellenspannung $V_\pi$ in Abhängigkeit von der effektiven Dicke $d_1$ des elektrooptisch aktiven Mediums zeigt, bei konstantem $d_1+d_2$;
Fig. 4    einen erfindungsgemässen Sensor in Reflexionsgeometrie, schematisch;
Fig. 5    einen erfindungsgemässen Sensor in Reflexionsgeometrie, schematisch;
Fig. 6    einen erfindungsgemässen Sensor in Transmissionsgeometrie, schematisch;
Fig. 7    einen zwei Sensorstäbe umfassenden erfindungsgemässen Sensor für hohe Spannungen, schematisch;
Fig. 8    einen erfindungsgemässen Sensor, in Silikon eingegossen, schematisch.

Die in den Zeichnungen verwendeten Bezugszeichen und deren Bedeutung sind in der Bezugszeichenliste zusammengefasst aufgelistet. Grundsätzlich sind in den Figuren gleiche oder zumindest gleichwirkende Teile mit gleichen Bezugszeichen versehen. Die beschriebenen Ausführungsbeispiele stehen beispielhaft für den Erfindungsgegenstand und haben keine beschränkende Wirkung.

Wege zur Ausführung der Erfindung

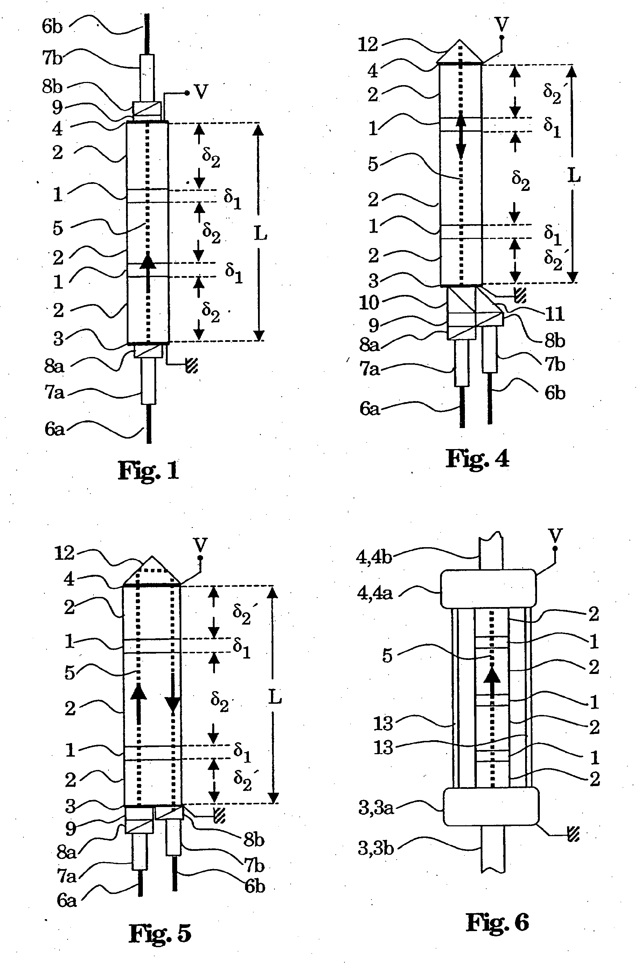

Fig. 1 zeigt einen Sensor in Transmissionsgeometrie, der N = 2 BGO-Kristall-Scheiben 1 und N+1 = 3 Scheiben Quarzglas umfasst. Dieser Stapel von BGO- und Quarzglas-Scheiben bildet einen Stab, einen Sensorstab. In Fig. 1 sind vor allem die optischen Komponenten dargestellt. Die BGO-Scheiben 1 haben eine Dicke $\delta_1$ und sind zwischen den Quarzglas-Scheiben 2 der Dicke $\delta_2$ angeordnet. Vorteilhaft sind alle Scheiben zylindrisch mit demselben Durchmesser. Vorteilhaft haben alle BGO-Scheiben dieselbe kristalline Orientierung. An jedem Ende des Stapels aus BGO- und Quarzglas-Scheiben ist vorzugsweise je eine Elektrode 3,4 angebracht. Diese ist vorteilhaft aus ITO (Indium-Zinn-Oxid), so dass sie transparent ist. Die erste Elektrode 3 liegt auf Erdpotential, die zweite Elektrode 4 auf dem Potential V. Die Spannung V ist zu messen.

In dem elektrooptisch aktiven Medium 1 breitet sich ein Lichtstrahl 5 aus. Über eine optische Zuführungsfaser 6a, vorteilhaft eine Multimode-Faser, wird von einer nicht-dargestellten Lichtquelle erzeugtes Licht zugeführt. Als Lichtquelle dient vorteilhaft eine Licht-emittierende Diode (LED), eine superlumineszente Diode oder eine Multimode-Laserdiode. Das Licht 5 wird einer Kollimatorlinse 7a und dann einem Polarisator 8a zugeführt. Durch die transparente Elektrode 3 gelangt das Licht 5 in den Stapel von BGO- und Quarzglas-Elementen. In dem Stapel breiten sich dann vorteilhaft zwei zueinander orthogonal polarisierte Lichtwellen aus.

Durch den elektrooptischen Effekt oder Pockels-Effekt (=linearer elektrooptischer Effekt) wird der Polarisationszustand des Lichtes 5 in dem elektrooptisch aktiven Medium 1 (BGO) verändert, da eine spannungsinduzierte Doppelbrechung erzeugt wird. Die Grösse der Beeinflussung des Polarisationszustandes des Lichtes 5 hängt von der Grösse des elektrischen Feldes in den BGO-Elementen, also von der Spannung V, ab. Wenn sich in dem elektrooptisch aktiven Medium 1 zwei zueinander orthogonal polarisierte Lichtwellen ausbreiten, kann durch den elektrooptischen Effekt eine Verzögerung der einen gegenüber den anderen Lichtwellen erreicht werden, so dass sich eine Phasenverschiebung zwischen den Lichtwellen ergibt. In guter Näherung ist diese Phasenverschiebung proportional zu der zu messenden Spannung V.

Nach Durchlaufen des Stapels tritt das Licht 5 durch die Elektrode 4, durch ein $\lambda/4$-Element 9, durch einen Polarisator 8b und eine Kollimatorlinse 7b und wird schliesslich mittels der optischen Faser 6b, die vorteilhaft eine Multimode-Faser ist, einer nicht-dargestellten Detektions-Auswerte-Einheit zugeführt. Die Polarisatoren 8a,8b sind vorteilhaft entlang der [100]-Richtung der BGO-Kristalle und somit unter 45° zu den im BGO-Material induzierten Achsen der Doppelbrechung orientiert. Die Achsen des $\lambda/4$-Elementes 9 sind parallel zu den im BGO-Material induzierten Achsen der Doppelbrechung orientiert. In der nicht-dargestellten Detektions-Auswerte-Einheit wird die spannungsinduzierte Veränderung des Polarisationszustandes des Lichtes 5, insbesondere mittels einer aufgrund der Phasenverschiebung erzeugten Änderung einer normierten Lichtintensität, bestimmt und daraus ein Mass für die Spannung V, das Spannungssignal, gewonnen. Grundlagen und Details zur elektrooptischen Spannungsmessung können dem Stand der Technik entnommen werden, beispielsweise der genannten EP 0 682 261 A2. Weitere Grundlagen der elektrooptischen Spannungsmessung und Detektion sind beispielsweise der Publikation G.A. Massey, D.C. Erickson, and R.A. Kadlec, Applied Optics 14, 2712-2719, 1975 zu entnehmen.

Die effektive Dicke des elektrooptisch aktiven Mediums 1 (BGO) ist in Fig. 1 gleich $d_1 = 2 \cdot \delta_1$. Die effektive Dicke des Abstandsmediums 2 (Quarzglas) ist gleich $d_2 = 3 \cdot \delta_2$. Mit $\delta$ sind die effektiven Dicken der einzelnen Elemente der Medien 1,2 bezeichnet. L bezeichnet einen effektiven Abstand der Elektroden 3,4 voneinander. In Fig. 1 sind entlang der gesamten Länge L die zwei Medien 3,4 angeordnet.

Durch eine geeignete Wahl der effektiven Dicken $d_1,d_2$ kann die relative Temperaturabhängigkeit des elektrischen Feldes in den BGO-Scheiben 1 beeinflusst werden. Dies kann zur Kompensation der Temperaturabhängigkeit des elektrooptischen Effektes eingesetzt werden, wie im folgenden gezeigt wird. Es werden hier nur zwei verschiedene Materialien 1,2 betrachtet, wobei ausserdem gegenüber den Temperaturabhängigkeiten von massgeblichen elektrooptischen Koeffizienten k und Dielektrizitätskonstanten $\varepsilon$ Einflüsse der Temperaturabhängigkeiten weiterer Grössen, wie beispielsweise des thermischen Ausdehnungskoeffizienten $\alpha$, vernachlässigt werden. Ein Einfluss der Temperaturabhängigkeit des thermischen Ausdehnungskoeffizienten $\alpha$ kommt sowieso im allgemeinen erst dann zum tragen, wenn sich die thermischen Ausdehnungskoeffizienten $\alpha_1$ und $\alpha_2$ der zwei Medien 1,2 voneinander unterscheiden.

In einem Sensor wie dem in Fig. 1 dargestellten mit einem elektrooptisch aktiven Medium 1 (BGO) und einem Abstandsmedium 2 (Quarzglas), welches im Falle von Quarzglas nicht elektrooptisch aktiv ist, gilt für die relative Temperaturabhängigkeit der elektrischen Feldstärke $E_1$ in dem Medium 1:

$$(1/E_1) \cdot (\partial E_1/\partial T) = [d_2 / (\varepsilon_2 \cdot d_1 + \varepsilon_1 \cdot d_2)] \cdot [(\varepsilon_1/\varepsilon_2)(\partial \varepsilon_2/\partial T) - (\partial \varepsilon_1/\partial T)] ,$$

wobei $\varepsilon_1$ die Dielektrizitätskonstante des elektrooptisch aktiven Mediums 1 und $\varepsilon_2$ die Dielektrizitätskonstante des Abstandsmediums 2 ist. Die elektrische Feldstärke $E_1$ in dem Medium 1 kann in der Näherung unendlich ausgedehnter Stapel-Elemente (Scheibenradius unendlich) angegeben werden als

$$E_1 \approx \varepsilon_2 \cdot V / (\varepsilon_2 \cdot d_1 + \varepsilon_1 \cdot d_2) \, .$$

Für BGO gilt $\varepsilon_1$ = 16.3, für Quarzglas $\varepsilon_2$ = 3.8.

Werden beide Medien 1,2 durchstrahlt, wobei beide elektrooptisch aktiv sein können, so gilt im Falle der temperaturkompensierenden Wahl der Dicken $d_1, d_2$:

$$d_1 \cdot [(\partial k_1/\partial T) \cdot E_1 + k_1 \cdot (\partial E_1/\partial T)] + d_2 \cdot [(\partial k_2/\partial T) \cdot E_2 + k_2 \cdot (\partial E_2/\partial T)] \approx 0 \, ,$$

wobei $k_1, k_2$ die massgeblichen elektrooptischen Koeffizienten der Medien 1,2 sind. Es gilt dabei für die relativen Temperaturabhängigkeiten $(1/E_1) \cdot (\partial E_1/\partial T$ und $(1/E_2) \cdot (\partial E_2/\partial T)$ der elektrischen Felder in den Medien 1,2 in der oben genannten Näherung unendlich ausgedehnter Stapel-Elemente:

$$(1/E_1) \cdot (\partial E_1/\partial T) \approx [d_2/(\varepsilon_1 \cdot d_2 + \varepsilon_2 \cdot d_1)] \cdot [\, (\varepsilon_1/\varepsilon_2)\,(\partial \varepsilon_2/\partial T) - (\partial \varepsilon_1/\partial T)]$$

und

$$(1/E_2) \cdot (\partial E_2/\partial T) \approx [d_1/(\varepsilon_1 \cdot d_2 + \varepsilon_2 \cdot d_1)] \cdot [\, (\varepsilon_2/\varepsilon_1)\,(\partial \varepsilon_1/\partial T) - (\partial \varepsilon_2/\partial T)] \, .$$

Es wird dabei vorausgesetzt, dass die Dicken $d_1, d_2$ im wesentlichen keine Temperaturabhängigkeit aufweisen.

Ist das Abstandsmedium 2 nicht elektrooptisch aktiv oder wird es nicht von dem Licht 5 durchstrahlt, so gilt:

$$d_1 \cdot [(\partial k_1/\partial T) \cdot E_1 + k_1 \cdot (\partial E_1/\partial T)] \approx 0 \, ,$$

und somit

$$(\partial k_1/\partial T) \cdot E_1 + k_1 \cdot (\partial E_1/\partial T) \approx 0 \, ,$$

wobei für die relative Temperaturabhängigkeit $(1/E_1) \cdot (\partial E_1/\partial T)$ des elektrischen Feldes in dem Medien 1 in der oben genannten Näherung unendlich ausgedehnter Stapel-Elemente ebenfalls die bereits oben angegebene Gleichung

$$(1/E_1) \cdot (\partial E_1/\partial T) \approx [d_2/(\varepsilon_1 \cdot d_2 + \varepsilon_2 \cdot d_1)] \cdot [\, (\varepsilon_1/\varepsilon_2)\,(\partial \varepsilon_2/\partial T) - (\partial \varepsilon_1/\partial T)]$$

gilt. Daraus ergibt sich als explizite Bedingung für die Dicken $d_1, d_2$:

$$[d_1/(\varepsilon_1 \cdot d_2 + \varepsilon_2 \cdot d_1)] \cdot [(\varepsilon_2/\varepsilon_1) \cdot (\partial \varepsilon_1/\partial T) - (\partial \varepsilon_2/\partial T)] + (1/k_1) \cdot (\partial k_1/\partial T) \approx 0 \, .$$

Die obigen Gleichungen ergeben sich aus der Bedingung, dass die Temperaturabhängigkeit der detektierten Polarisationszustandsänderung des Lichtes 5 null sein soll, woraus

$$(\partial/\partial T) [k_1 \cdot E_1 \cdot d_1 + k_2 \cdot E_2 \cdot d_2] = 0$$

folgt.

Die Orientierung der BGO-Kristalle in Fig. 1 ist vorteilhaft so gewählt, dass die [001]-Kristallachse entlang des elektrischen Feldes E zwischen den Elektroden 3,4 ausgerichtet ist. Die Ausbreitungsrichtung des Lichtes 5 in den BGO-Kristallen verläuft parallel zu dieser Richtung. Auf diese Weise führen nur solche Komponenten des elektrischen Feldes, die ebenfalls entlang dieser Richtung verlaufen, zu einer Veränderung des Polarisationszustandes des Lichtes 5. Dadurch ist der Sensor unempfindlich gegenüber Störungen des elektrischen Feldes, beispielsweise durch in der Nähe des Sensors angeordnete Hochspannungspole. Andere äussere Störungen des elektrischen Feldes werden beispielsweise hervorgerufen durch Verunreinigungen der Oberfläche eines den Sensor isolierenden Isolators oder durch bewegte elektrisch leitende Objekte nahe dem Sensor.

In der genannten Geometrie ist der massgebliche elektrooptische Koeffizient $k_1$ des elektrooptisch aktiven Mediums 1 (BGO) gegeben als

$$k_1 = n_0^3 r_{41} \ ,$$

wobei $n_0$ der Brechungsindex des BGO-Kristalls 1 und $r_{41}$ das relevante elektrooptische Tensorelement für kristallines BGO 1 ist. Für BGO beträgt $k_1$ = 9.8 pm/V (P.A. Williams et al., Applied Optics 35, 3562-3569, 1996). Die relative Temperaturabhängigkeit von $k_1$ beträgt für BGO gemäss der genannten Publikation von Williams et al.

$$(1/k_1) \cdot (\partial k_1 / \partial T) = 1.54 \times 10^{-4} /°C \ .$$

Gemäss j. Link, j. Fontanella, j. Appl. Phys. 51, 4352, 1980 beträgt die relative Temperaturabhängigkeit der Dielektrizitätskonstante $\varepsilon_1$ von BGO

$$(1/\varepsilon_1) \cdot (\partial \varepsilon_1 / \partial T) = 1.8 \times 10^{-4} /°C \ .$$

Da das in Fig. 1 eingesetzte Abstandsmedium 2 Quarzglas und somit nicht elektrooptisch aktiv ist und eine vernachlässigbare Temperaturabhängigkeit seiner Dielektrizitätskonstanten $\varepsilon_2$ aufweist (zumindest in dem für typische Anwendungen relevanten Temperaturbereich zwischen -40 °C und 80 °C; siehe beispielsweise DIELECTRIC MATERIALS AND APPLICATIONS, edited by Arthur R. von Hippel, Cambridge, Mass., M.I.T., 1954), ist die Berechnung der für eine Temperaturkompensation geeigneten Dicken $d_1, d_2$ einfach.

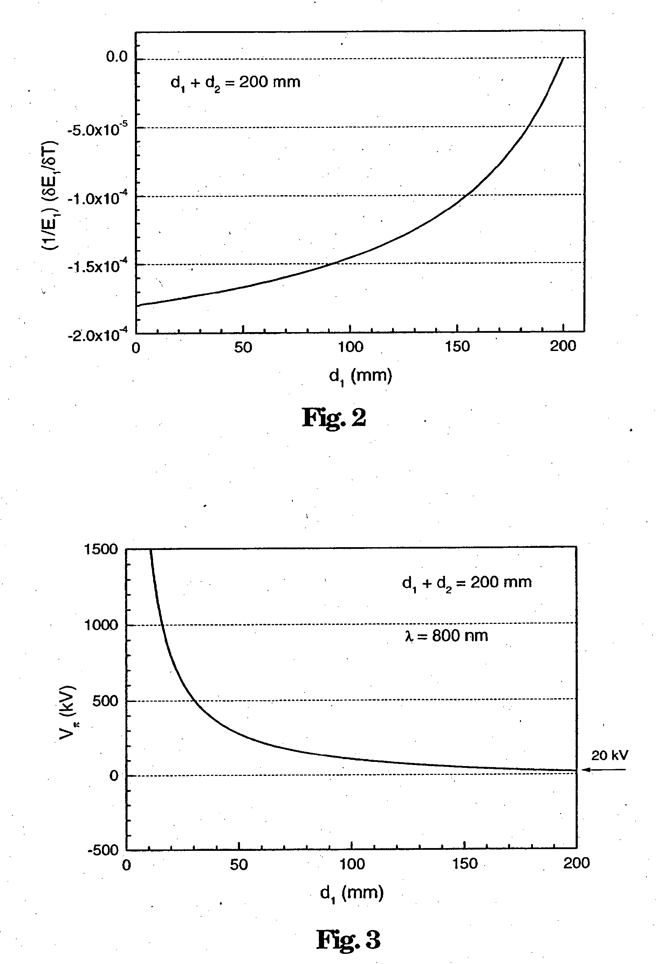

Fig. 2 zeigt eine berechnete Kurve, die die Möglichkeit der Temperaturkompensation veranschaulicht. Auf der vertikalen Achse ist die relative Temperaturabhängigkeit $(1/E_1) \cdot (\partial E_1 / \partial T)$ der elektrischen Feldstärke $E_1$ in BGO 1 aufgetragen. Auf der horizontalen Achse ist die effektive Dicke $d_1$ des BGO aufgetragen. Als Abstandsmedium 2 ist weiterhin Quarzglas angenommen, und es wird L = $d_1 + d_2$ = 200 mm vorausgesetzt, wobei L der effektive Abstand der Elektroden 3,4 voneinander ist. Der in Fig. 2 dargestellten Kurve ist zu entnehmen, dass für $d_1$ = 84 mm (und $d_2$ = 116 mm) die relative Temperaturabhängigkeit $(1/E_1) \cdot (\partial E_1 / \partial T)$ der elektrischen Feldstärke $E_1$ in BGO 1 genau -1.54$\times$10$^{-4}$/°C beträgt, so dass die Temperaturabhängigkeit des massgeblichen elektrooptischen Koeffizienten $k_1$ exakt aufgehoben wird. Durch die genannte Wahl der effektiven Dicken $d_1, d_2$ wird also erreicht, dass der Einfluss der Temperatur auf den detektierten Polarisationszustand des Lichtes 5 kompensiert ist.

Eine Wahl von $d_1$ = 20 mm ergibt $(1/E_1) \cdot (\partial E_1 / \partial T)$=-1.75$\times$10$^{-4}$/°C, so dass immer noch eine gute Kompensation gegeben ist. Um im Temperaurintervall -40 °C bis 85 °C innerhalb eines Maximalfehlers von $\pm$0.2 % zu bleiben (IEC-Norm Klasse 0.2) muss $(1/E_1) \cdot (\partial E_1 / \partial T)$ im Bereich -(1.54$\pm$0.3)$\times$10$^{-4}$/°C liegen. Dies erlaubt eine Wahl von $d_1$ im Bereich zwischen 0 mm und 130 mm.

Wenn statt BGO ein anderes elektrooptisch aktives Medium 1 eingesetzt wird, bei welchem der massgebliche elektrooptische Koeffizient $k_1$ mit der Temperatur nicht zu- sondern abnimmt, muss $(1/E_1) \cdot (\partial E_1 / \partial T)$ positiv sein, oder genauer: der Term $(\varepsilon_1 / \varepsilon_2) \cdot (\partial \varepsilon_2 / \partial T) - \partial \varepsilon_1 / \partial T$ muss positiv sein:

$$(\varepsilon_1 / \varepsilon_2) \cdot (\partial \varepsilon_2 / \partial T) - \partial \varepsilon_1 / \partial T > 0 \ .$$

Diese Bedingung kann erfüllt werden, indem als Abstandsmedium 2 Alkalioder Erdalkali-Gläser verwendet werden. Die Werte von $\varepsilon_2$ und $\partial \varepsilon_2 / \partial T$ können durch geeignete Materialwahl in weiten Bereichen variiert werden, beispielsweise bis zu $\varepsilon_2$ = 12 und $\partial \varepsilon_2 / \partial T$ = 5$\times$10$^{-3}$/°C. Siehe beispielsweise die genannte Publikation DIELECTRIC MATERIALS AND APPLICATIONS, edited by Arthur R. von Hippel, Cambridge, Mass., M.I.T., 1954. In Frage kommen beispielsweise $K_2O$, $Na_2O$, $Li_2O$ und/oder $B_2O_3$ als Zusatz in $SiO_2$.

Genauere Resultate für Dicken $d_1, d_2$ für eine Temperaturkompensation können erhalten werden, wenn die endliche Ausdehnung der Medien 1,2 in Betracht gezogen wird. Weitere Korrekturen sind möglich, indem eine Isolierung des Sensors einbezogen wird. Weiter unten wird eine Ummantelung des Sensors mit Silikon dargestellt, welche die elektrische Feldverteilung beeinflusst und eine Temperaturabhängigkeit aufweist. Die genannten Korrekturen können beispielsweise mittels numerischer Simulationen der elektrischen Feldverteilung vorgenommen werden.

Die effektive Dicke $d_1$ entspricht in dem Ausführungsbeispiel von Fig. 1 der Gesamtlänge der BGO-Elemente. In Fällen, in denen das elektrooptisch aktive Medium 1 und/oder das Abstandsmedium 2 andersartig geformt und/oder angeordnet ist, beispielsweise in Form von Elementen mit einer nicht-glatten Oberfläche und/oder mit nicht senkrecht zur Feldrichtung ausgerichteten Flächen, ist eine Dicke eines der Medien 1,2 nicht so einfach geometrisch definiert. In solchen Fällen müssen daher effektive Dicken $d_1,d_2$ berechnet oder anderweitig bestimmt werden. Unter einer effektiven Dicke $d_1,d_2$ ist eine solche Dicke zu verstehen, die bezüglich seiner Temperaturabhängigkeit der in Betracht gezogenen Grössen (k, $\varepsilon$ und gegebenenfalls weiterer Grössen) gleichwirkend ist wie ein zwischen den Elektroden 3,4 angeordnetes zylinderförmiges Scheiben-Element mit senkrecht zur Feldrichtung ausgerichteten Flächen (siehe beispielsweise Fig. 1) der entsprechenden geometrischen Dicke.

Für die Temperaturkompensation ist es nicht notwendig, die Medien 1,2 in jeweils mehreren einzelnen Elementen anzuordnen. Man kann im Prinzip auch einen einzigen BGO-Kristall (N = 1) nehmen und/oder auch das Abstandsmedium 2 in einem einzigen Element anordnen. Eine symmetrischere und gleichmässigere Verteilung von mehreren (N $\geq$ 2) Elementen zwischen den Elektroden 3,4 ist aber vorteilhaft für die Genauigkeit der Spannungsmessung und insbesondere für die Unempfindlichkeit der Spannungsmessung gegen äussere Störungen des elektrischen Feldes. Die Elemente, insbesondere die Elemente des elektrooptisch aktiven Mediums 1, werden vorteilhaft derart angeordnet, dass die Abweichung zwischen der (exakten) Linienintegration $\int E_{1,x}(x) \cdot dx$ über das elektrische Feld zwischen den Elektroden 3,4 und einer (gegebenenfalls gewichteten) Summe $\Sigma a_i E_{1,x}(x_i)$ über die in den einzelnen Elementen des elektrooptisch aktiven Mediums 1 herrschenden lokalen Felder minimal ist:

$$\int E_{1,x}(x) \cdot dx - \Sigma\, a_i\, E_{1,x}(x_i) \approx 0$$

In dem Patent US 4'939'447 und in der Publikation Optics Letters 14, 290, 1989 sind Details dazu angegeben.

Eine optimierte Anordnung der Elemente kann durch Berechnungen oder auch durch Simulationen oder experimentell gefunden werden. Recht gute Ergebnisse können auch mit zwei einfachen Anordnungen erzielt werden:

(1) Alle Elemente des Mediums 1 weisen dieselbe Dicke $\delta_1$ auf, und die äusseren zwei Elemente des Mediums 2 weisen dieselbe Dicke $\delta_2$' auf, welche halb so gross ist wie die Dicke $\delta_2$ eventueller weiterer Elemente des Mediums 2.

(2) Wie in Fig. 1 weisen alle Elemente des Mediums 1 dieselbe Dicke $\delta_1$ auf, und alle Elemente des Mediums 2 weisen dieselbe Dicke $\delta_2$ auf.

Die in der obigen Gleichung angegebenen Gewichtungsfaktoren $a_i$ werden vorteilhaft dann verwendet, wenn die einzelnen Elemente des elektrooptisch aktiven Mediums 1 verschiedene effektive Dicken aufweisen und/oder wenn es möglich ist, den Beitrag verschiedener Elemente einzeln zu erfassen. Letzteres ist möglich, beispielsweise indem nicht, wie in Fig. 1 dargestellt, ein einziger Lichtstrahl 5 alle Elemente durchstrahlt, sondern wenn mehrere Lichtstrahlen verwendet werden, die jeweils ein Element oder auch mehrere Elemente durchstrahlen.

Ein weiterer grosser Vorteil der Anordnung mindestens zweier Medien 1,2 zwischen den Elektroden 3,4 ist, dass dadurch ermöglicht wird, auch hohe Spannungen V eindeutig zu messen. Es wird ermöglicht, eine grosse Halbwellenspannung $V_{\Pi}$ des Sensors zu haben, während trotzdem eine hohe dielektrische Festigkeit aufgewiesen wird. Denn über den gesamten Abstand L zwischen den Elektroden 3,4 kann in Form der Medien 1,2 Materie in festem Aggregatzustand angeordnet werden, so dass zwischen den Elektroden 3,4 Materialien mit vergleichbaren Dielektrizitätskonstanten angeordnet sind, so dass zwischen den Elektroden 3,4 keine grossen Sprünge der elektrischen Feldstärke auftreten.

Fig. 3 zeigt eine berechnete Kurve, die veranschaulicht, wie sich die Halbwellenspannung $V_{\Pi}$ des Sensors mit der Dicke $d_1$ verändert, wobei $d_1 + d_2$ konstant gleich L = 200 mm gewählt ist. Die Medien 1,2 sind wieder BGO und Quarzglas. Wenn sich, wie im Zusammenhang mit Fig. 1 angegeben, zwei zueinander orthogonal polarisierte Lichtwellen in dem BGO 1 ausbreiten, so gilt für die elektrooptisch induzierte Phasenverschiebung zwischen diesen Lichtwellen:

$$\Gamma = k_1 \cdot V \cdot 2\pi/\lambda\,,$$

wobei $\lambda$ die Wellenlänge des Lichtes 5 ist. Bei $\lambda$ = 800 nm ergibt sich für V = 20 kV eine Phasenverschiebung $\Gamma = \pi/2$ und somit $V_\pi$ = 40 kV (in Transmissionsgeometrie, wie in Fig. 1 dargestellt). Spannungen von mehr als 40 kV sind also nicht mehr eindeutig messbar.

Werden nun, wie in Fig. 1 dargestellt, zwei Medien 1,2 benutzt, so ergibt sich eine Phasenverschiebung $\Gamma^*$, die erheblich geringer sein kann als die oben angegebene Phasenverschiebung $\Gamma$ :

$$\Gamma^* = \Gamma \cdot \varepsilon_2 d_1 \,/\, (\varepsilon_2 d_1 + \varepsilon_1 d_2)$$

Für $d_1$ = 20 mm und d2 = 180 mm ergibt sich $\Gamma^*$ = 0.025·$\Gamma$, so dass sich statt $V_\pi$ = 40 kV ergibt: $V_\pi$ = 800 kV. Die Halbwellenspannung $V_\pi$ ist also drastisch erhöht. Fig. 3 gibt Halbwellenspanungen $V_\pi$ für verschiedene $d_1$ an.

Eine weitere Möglichkeit, eine grössere Halbwellenspanung $V_\pi$ zu erzielen, ist, Licht 5 einer grösseren Wellenlänge $\lambda$ zu verwenden.

Fig. 4 zeigt einen weiteren möglichen Aufbau des Sensors. Dieser entspricht weitgehend dem in Fig. 1 dargestellten Aufbau. Er wird ausgehend davon beschrieben. Die äusseren zwei Elemente des Mediums 2 weisen dieselbe Dicke $\delta_2$' auf, welche halb so gross ist wie die Dicke $\delta_2$ des weiteren Elements des Mediums 2, welches zwischen den beiden BGO-Kristallen 1 angeordnet ist (siehe auch oben, Version (1) der einfachen Anordnungen der Elemente). Anstatt in Transmission (Fig. 1) arbeitet der Sensor in Fig. 4 in Reflexion. An einem Ende des Stapels, vorzugsweise an dem hochspannungsseitigen, ist ein reflektierendes Prisma 12 angeordnet, welches den Lichtstrahl 5 zurück in den Stapel lenkt. Somit durchläuft der Lichtstrahl 5 die Medien 1,2 zweimal. Durch das zweimalige Durchlaufen halbiert sich gegenüber der Transmissionskonfiguration (Fig. 1) die Halbwellenspannung $V_\pi$. In Vergleich zu der oben diskutierten Ausführungsform wäre also $V_\pi$ = 20 kV statt 40 kV.

Das $\lambda$/4-Element 9 kann, wie in Fig. 4 dargestellt, am Eingang, oder auch am Ausgang (nicht dargestellt) angeordnet sein. An der Elektrode 3 ist ein Strahlteiler 10 angeordnet, der der Einkopplung und Auskopplung des Lichtstrahles 5 dient. An dem Strahlteiler 10 ist vorteilhaft ein Umlenkprisma 11 angeordnet. Ein grosser Vorteil der Reflexgeometrie ist, dass auf der Hochspannugsseite keine optischen Zuleitungen (Fasern) angeordnet sein müssen, welche das Potential zwischen den beiden Elektroden 3,4 überbrücken müssten.

In Fig. 5 ist ein weiterer möglicher Aufbau des Sensor dargestellt. Dieser entspricht weitgehend dem in Fig. 4 dargestellten Aufbau und ist ebenfalls in Reflexkonfiguration. Er wird ausgehend davon beschrieben. Anstatt, wie in Fig. 4, den Lichtstrahl über den Strahlteiler 10 weitgehend zentral in den Stapel einzukoppeln, verläuft der Lichtstrahl 5 vor und nach der Umlenkung in dem reflektierenden Prisma 12 auf zwei deutlich beabstandeten, zueinander im wesentlichen parallelen Wegen. Dadurch wird kein Strahlteiler 10 benötigt, und ebensowenig ein Umlenkprisma 11.

Fig. 6 illustriert eine weitere vorteilhafte Ausführungsform des Sensors. Details der Optik, welche in den Fig. 1, 4 und 5 dargestellt sind, sind hier zum Teil nicht dargestellt. Der in Fig. 6 dargestellte Sensor arbeitet in Transmission, kann aber ebensogut reflektiv, wie beispielsweise in Figs. 4 oder 5 dargestellt, betrieben werden. Hier ist der Fall N = 3 dargestellt, es gibt also drei BGO-Elemente. Die Elektroden 3,4 umfassen hier einen nicht-dargestellten transparenten Teil, durch welchen das Licht in den Stapel gelangt und ausgekoppelt wird. Weiter beinhalten die Elektroden 3,4 je eine Feldsteuerungselektrode 3a,4a, welche den Stapel seitlich überragt und die mit dem jeweiligen transparenten Teil leitend verbunden ist. Die Feldelektroden sind im wesentlichen scheibenförmige ausgebildet. Weiter beinhalten die Elektroden 3,4 je eine Spannungszuführung 3b,4b, welche im wesentlichen stabförmig ausgebildet ist. Zur mechanischen Stabilisierung des Sensors weist dieser mehrere (vorteilhaft 3, 4, 5, 6, 7 oder 8) Isolatorstäbe 13 auf, welche die Feldsteuerungselektroden 3a,4a mechanisch miteinander verbinden.

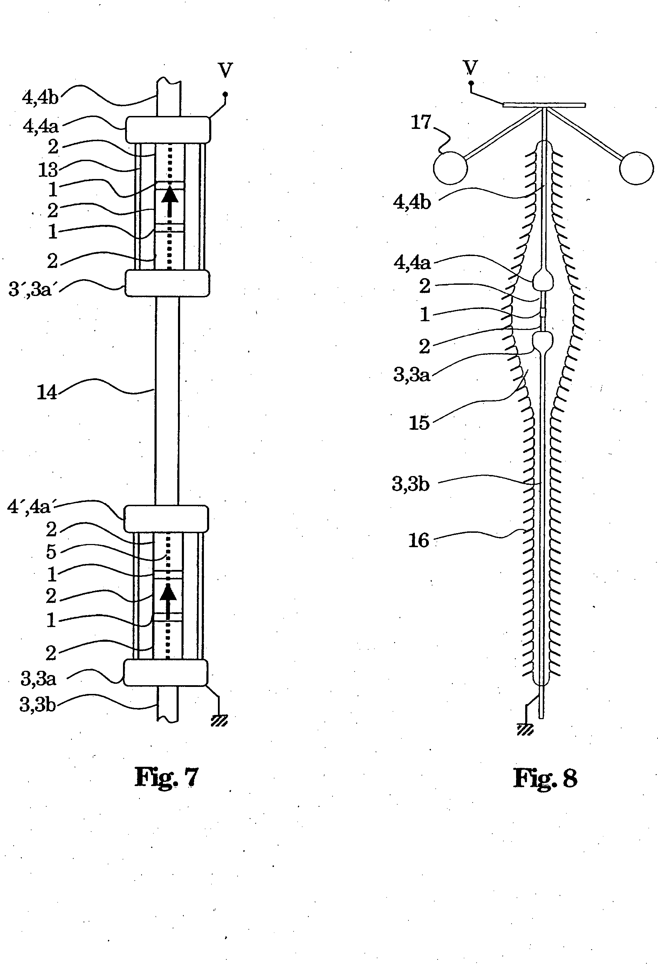

In Fig. 7 ist eine weitere vorteilhafte Ausführungsform dargestellt, welche besonders geeignet ist zur Messung sehr hoher Spannungen. Dieser Sensor besteht im wesentlichen aus zwei seriell geschalteten Sensoren, welche, wie dargestellt, beispielsweise ähnlich den in Fig. 6 dargestellten sein können. Das zu messende Potential liegt zwischen der Elektrode 3 des einen Sensorteils und der Elektrode 4 des anderen Sensorteils an. Zwischen der Elektrode 4' des einen Sensorteils und der Elektrode 3' des anderen Sensorteils ist ein metallischer Verbindungsstab 14 angeordnet, der die beiden Sensorteile leitend und mechanisch miteinander verbindet. Es ist auch möglich, noch mehr, also 3, 4 oder 5 usw. Sensorteile zu einem Sensor zusammenzufassen.

Wenn ein Sensor mehrere seriell geschaltete Sensoren umfasst, ist es möglich, diese mittels mehrerer Lichtstrahlen 5 oder auch mittels nur eines Lichtrahles 5 zu betreiben. Vorteilhaft kann dann der letzte Teilsensor am Hochspannungsende des Sensors reflektiv und die anderen transmittiv aufgebaut sein.

Anstatt zur Bewältigung hoher Spannungen zwei oder mehr Sensorstäbe einzusetzen ist es auch möglich, einen grösseren Elektrodenabstand L zu wählen. Dann werden vorteilhaft mehr also N = 2, als 3, 4 oder 5 oder mehr Elemente des elektrooptisch aktiven Mediums 1 eingesetzt.

In Fig. 8 ist eine weitere vorteilhafte Ausführungsform dargestellt. Auf die Darstellung von Details der Optik wurde hier verzichtet, während hier mehr auf die Isolierung des Sensors eingegangen wird.

Am hochspannungseitigen Ende des Sensors ist ein Koronaring 17 angeordnet. Die Spannungszuführungen 3b,4b der Elektroden 3,4, die Feldsteuerungselektroden 3a,3b und die Medien 1,2 sind ummantelt mit Silikon 15. Vorteilhaft sind die wesentlichen Teile des Sensors eingegossen in Silikon 15. Vorteilhaft weist die Silikonummantelung 15 aussen Lamellen 16 auf, welche eine Beschirmung bilden. Vorteilhaft ist die ganze Silikonummantelung 15 einstückig ausgebildet. Die Feldsteuerungselektroden 3a,4a sind im wesentlichen scheibenförmig ausgebildet. Sie sind in dem Sinne im wesentlichen scheibenförmig ausgebildet, dass sie auf ihrer der jeweils anderen Elektrode 4,3 zugewandten Seite im wesentlichen flach sind und im wesentlichen rund sind. Auf diese Weise ist das elektrische Feld E zwischen den Elektroden 3,4 sehr homogen und parallel verlaufend.

Im Bereich der Feldelektroden 3a,4a und der Medien 1,2 ist die Silikonummantelung 15 zylinder- oder tonnenförmig ausgebildet. Der Durchmesser der Silikonummantelung 15 ist vorteilhaft etwas grösser als der Durchmesser der Feldelektroden 3a,4a , insbesondere 1.1-mal bis zu 6-mal so gross, und vorteilhaft zwischen 2- und 4-mal, so gross ist wie der Durchmesser der Feldelektroden 3a,4a oder, allgemeiner, wie eine maximale radiale Ausdehnung der Elektroden 3,4. Vorteilhaft ist die Dicke der Silikonummantelung 15 oder ihr Durchmesser so gross gewählt, dass die elektrische Feldstärke aussen auf der Silikonummantelung 15 bei anliegender Spannung V maximal 35 kV/mm, insbesondere maximal 30 kV/mm beträgt. In besonderen Fällen kann eine Beschichtung mit Silikon ausreichend sein oder eine Ummantelung mit Silikon 15, die den Sensor umgibt, wobei sie gegebenenfalls an manchen Stellen lediglich 1 mm dick ist.

Eine Silikonummantelung 15 hat den Vorteil, gegenüber herkömmlichen Isolierungen geringe Abmessungen und ein geringes Gewicht zu haben. Ausserdem ist sie wartungsfrei. Herkömmliche, gasisolierte Isolierungen benötigen oftmals eine Druck-Überwachung, die bei einer Isolierung mit Silikonummantelung 15 nicht benötigt wird. Ausserdem werden bei gasisolierten Isolationen gasdichte optische Durchführungen benötigt, derer ein Sensor mit Silikonummantelung 15 nicht bedarf. Gegenüber festen Isolationsmaterialien wie Polyurethan, die als Füllmaterial eingesetzt werden, hat Silikon den Vorteil, dass die Dielektrizitätskonstante von Silikon im Gegensatz zu der von Polyurethan eine deutlich geringere Temperaturabhängigkeit aufweist.

Ein für Betriebsspannungen von 240 kV ausgelegter Sensor kann vorteilhaft die folgenden Parameter aufweisen:

- Elektrodenabstand L = 200 mm
- Elektrodendurchmesser am im wesentlichen scheibenförmigen Bereich: 100 mm
- Medium 1 = BGO
- Medium 2 = Quarzglas
- $d_1$ = 80 mm, aufgeteilt in 2 Elemente von je 40 mm
- $d_2$ = 120 mm, aufgeteilt in 3 Elemente: 1×60 mm, 2×30 mm
- Silikonummantelungsdurchmesser: 300 mm im Bereich der Elektroden
- Silikonummantelungsdurchmesser: 80 mm im Bereich der Spannungszuführungen
- Lamellenlänge 5 cm

Ein Sensor für Betriebsspannungen von 550 kV umfasst vorteilhaft zwei solcher Sensoren für Betriebsspannungen von 240 kV (vergleiche Fig. 7).

Simulationsrechnungen haben gezeigt, dass ein Sensor mit erfindungsgemässem Sensorstab und Silikonummantelung 15 eine grosse Unempfindlichkeit gegen äussere Störungen des elektrischen Feldes aufweist. Beispielsweise ein Sensor der Art, wie er oben für die Betriebsspannung von 240 kV beschrieben ist, zeigt bei Wasserfilmen der Dicke 1 mm auf der Silikonummantelung 15 in der Nähe des Sensorstabes relative Abweichungen des Spannungssignals gegenüber dem ungestörten Zustand von deutlich unter 1 %. Ein auf der Höhe der Mitte des Sensorstabes angeordneter 40 mm langer Wasserfilm bewirkt beispielsweise einen relativen Spannungsabfall von nur 0.04 %. Ein geerdeter Metallzylinder in 2 m Abstand zum Sensor, der parallel zum Sensorstab ausgerichtet ist und diesen um 1 m überragt, erzeugt einen relativen Spannungsanstieg von nur 0.04 %.

Die weiter oben und im folgenden aufgeführten alternativen oder zusätzlichen Merkmale sind optional und untereinander sowie mit den in der Beschreibung dargestellten Ausführungsbeispielen beliebig kombinierbar.

Das elektrooptisch aktive Medium 1 kann irgendein elektrooptisch aktives Material sein, vorzugsweise ein elektrooptisch aktiver Kristall. In der genannten EP 0 682 261 A2 sind verschiedene geeignete elektrooptisch aktive Materialien angegeben.

Das Abstandsmedium 2 kann von gasförmigem, flüssigem oder vorteilhaft von festem Aggregatzustand sein. Es kann auch Vakuum sein. Es kann elektrooptisch aktiv oder nicht elektrooptisch aktiv sein. Vorteilhaft werden die Medien 1,2 auch derart gewählt, dass sie nur einen geringen Brechungsindexunterschied aufweisen. Das vermeidet grosse Reflexionsverluste an den Grenzflächen. Beispielsweise in dem oben genannten Beispiel mit BGO 1, das einen Brechungsindex von 2.07 bei 800 nm hat, und Quarzglas 2, dass einen Brechungsindex von 1.46 bei 800 nm hat, betragen die Reflexionsverluste etwa 3 % pro Reflexion. Ist das zweite Medium 2 ein Gas, beispielsweise $SF_6$, so ergeben sich etwa 12.1 % Reflexionsverlust pro Reflexion.

Zur Erzielung weiterer Freiheitsgrade bei der Auslegung des Sensors können auch Stapel der folgenden Art in Betracht gezogen werden: Anstatt einzelne BGO-Scheiben einzusetzen können auch paarweise Anordnungen von BGO-Kristallen verwendet werden, wobei ein Teilkristall des Paares gegenüber dem anderen Teilkristall kristallographisch anders orientiert ist. Die Orientierung wird derart gewählt, dass durch den elektrooptischen Effekt die Veränderung des Polarisationszustandes des Lichtes 5 in dem einen Teilkristall durch die Veränderung des Polarisationszustandes des Lichtes 5 in dem anderen Teilkristall des Paares teilweise wieder rückgängig gemacht wird, also teilweise aufgehoben wird. Insbesondere können die Teilkristalle zueinander gegensätzlich orientiert sein und voneinander verschiedene Dicken aufweisen. Es kann also eine Vergrösserung der Halbwellenspannung $V_\pi$ erzielt werden. Selbstverständlich können die Teilkristalle aus verschiedenen elektrooptisch aktiven Materialien bestehen. Man kann auch die Elemente aus dem zweiten Teilkristall als Elemente des Abstandsmediums 2 auffassen.

Die Medien 1,2 können vorteilhaft mittels eines transparenten Klebers miteinander verbunden sein.

Zwischen den Elektroden 3,4 können auch noch weitere elektrooptisch aktive Materialien und/oder weitere als ein Abstandsmedium 2 dienende Materialien angeordnet sein oder mehrere verschiedene Materialien als elektrooptisch aktives Medium 1 und/oder als Abstandsmedium 2 dienen. Aus dem oben geschriebenem ist dem Fachmann ist unmittelbar klar, wie er einen erfindungsgemässen Sensor mit mehr als zwei Medien aufzubauen hat.

Die Elektroden 3,4 sind vorteilhaft transparent. Transparent heisst hier durchlässig für die Wellenlänge des verwendeten Lichtes 5. Es ist aber auch denkbar, nicht-transparente Elektroden 3 und/oder 4 zu benutzen, wobei dann das Licht 5 beispielsweise an einer Ausnehmung, einem Loch, in der Elektrode 3 und/oder 4 ein- und/oder ausgekoppelt wird.

Der effektive Abstand L der Elektroden 3,4 ist in dem Ausführungsbeispiel von Fig. 1 die geometrische Länge, die das Licht 5 zwischen den Elektroden 3,4 zurücklegt. L entspricht somit dem geometrischen Minimalabstand zwischen den Elektroden 3,4. Der effektive Abstand L kann sich aber beispielsweise dann von dem geometrischen Abstand der Elektroden unterscheiden, wenn die Feldelektroden 3a,4a in radialer Richtung ein gebogenes Profil aufweisen, so dass der minimale geometrische Abstand zwischen den Feldelektroden 3a,4a im radialen Aussenbereich kleiner ist als im radialen Innenbereich, wo die transparenten Teile der Elektroden 3,4 angeordnet sind. Auch im Falle von nicht parallel zueinander ausgerichteter Elektroden 3,4 würde der geometrische minimale Abstand zwischen den Elektroden im allgemeinen nicht dem effektiven Abstand L der Elektroden 3,4 entsprechen. Der effektive Abstand L der Elektroden 3,4 kann von der Lichtführung abhängen.

Die effektiven Dicken $d_1,d_2$ der Medien 1,2 stimmen in den Ausführungsbeispielen der Figs. 1, 4, 5, 6, 7 mit der geometrischen Gesamtdicke der einzelnen Elemente des betreffenden Mediums 1,2 überein. Die effektiven Dicken $d_1,d_2$ können aber auch von einer solchen geometrischen Dicke abweichen. Beispielsweise wenn die Elemente eines Mediums nicht planparallel sind oder wenn die Elemente eines Mediums zwar wie in den Ausführungsbeispielen planparallel sind, aber bezüglich des Abstandes zwischen den Elektroden 3,4 gewinkelt angeordnet sind. Die effektiven Dicken $d_1,d_2$ der Medien 1,2 können dann von der Lichtführung abhängen.

Die effektive Dicke $d_1,d_2$ eines der Medien 1,2 gibt diejenige geometrische Gesamtdicke an, die das Medium 1,2 hätte, wenn es zwischen den Elektroden in Form eines oder mehrerer planparallel ausgebildeter Elemente angeordnet wäre und gleichwirkend wäre wie das Medium 1,2 in seiner tatsächlichen Form. Gleichwirkend heisst hier, dass bei der gleichen anliegenden Spannung V dieselbe Änderung des Polarisatonszustandes des Lichts 5 hervorgerufen wird. Die Ausrichtung der planparallelen Elemente ist dabei so zu wählen, dass die Senkrechte der planparallelen Flächen entlang des effektiven Abstandes L zwischen den Elektroden 3,4 verlaufen.

Für die effektive Dicke $d_1$ gilt $d_1 < L$. Es gilt weiterhin $d_1 + d_2 < L$ oder $d_1 + d_2 \leq L$. Die Dicken von verschiedenen Elementen der Medien 1,2 (insbesondere des elektrooptisch aktiven Mediums 1) innerhalb eines Sensorstabes kann variieren, beispielsweise um ungleichmässigen Feldverteilungen Rechnung zu tragen und genauere Messungen zu erzielen.

Das Licht 5 weist vorzugsweise eine geringe Kohärenzlänge auf. Vorzugsweise durchläuft ein Lichtstrahl 5 den ganzen Sensorstab (Stapel), da dadurch nur eine optische Zuleitung und eine optische Rückführung notwendig ist. Man kann aber auch eines oder mehrere Elemente mit jeweils einem Lichtstrahl 5 abfragen.

Je nach Art des elektrooptisch aktiven Mediums 1 und dessen kristalliner Orientierung sind auch Sensoren konstruierbar, bei denen der Lichtstrahl 5 nicht, wie in den dargestellten Ausführungsformen, parallel zur Achse des Sensorstabes oder parallel zu den Feldlinien des von der Spannung V erzeugten elektrischen Feldes verläuft (longitudinaler Pockels-Effekt). Beispielsweise kann das Licht 5 senkrecht dazu verlaufen (transversaler Pockel-Effekt). Im Falle mehrerer Elemente des elektrooptisch altiven Mediums 1 kann dann vorzugsweise jedes Element mit einem separaten Lichtstrahl durchstrahlt werden. Mittels Reflexionsmitteln und/oder optischen Fasern können aber auch mehrere oder alle Elemente des elektrooptisch aktiven Mediums 1 gemeinsam von einem Lichtstrahl 5 durchstrahlt werden. Im allgemeinen weist ein derartiger Sensor aber eine grosse Querempfindlichkeit auf (Beeinflussung durch äussere Felder, die nicht die gleiche Ausrichtung haben wie das zu messende Feld).

Die optische Zuführungsfaser 6a kann eine Multimodefaser oder vorteilhaft auch eine polarisationserhaltende Single-Mode-Faser sein. Letztere führt linear polarisiertes und hat den Vorteil, dass sie weniger anfällig ist auf biegeinduzierte Intensitätsverluste.

Die Silikonummantelung 15 kann selbstverständlich nicht nur der Isolation eines temperaturkompensierten Sensors dienen, sondern kann auch für einen beliebigen anderen, vorzugsweise elektrooptischen, Spannungssensor verwendet werden. Insbesondere für einen elektrooptischen Spannungssensor, bei dem zwischen den Elektroden 3,4 ein Sensorstab, insbesondere ein Sensorstab umfassend eines oder mehrere Medien 1,2 von festem Aggregatzustand, angeordnet ist.

Anstelle von Silikonummantelungen 15 können auch Isolationsrohre, vorzugsweise aus glasfaserverstärktem Kunststoff, zur Isolation des Sensors eingesetzt werden. Ein solches Isolationsrohr ist mit einer Isolationsfüllung gefüllt, die beispielsweise gasförmig sein kann, $SF_6$ oder $N_2$ zum Beispiel, oder ein Feststoff sein kann, Polyurethan zum Beispiel. In dem Isolationsrohr ist dann der Sensor angeordnet, der beispielsweise auch aus zwei, drei oder mehr seriell geschalteten Sensoren bestehen kann (vergleiche Fig. 7).

Wenn erfindungsgemäss Einflüsse der Temperatur auf den detektierten Polarisationszustand des Lichtes 5 im wesentlichen kompensiert sind oder sich Temperatureinflüsse gegenseitig im wesentlichen aufheben, soll das bedeuten, dass eine Verringerung der Temperatureinflüsse erzielt wird, und insbesondere dass die Temperatureinflüsse durch die Kompensation so klein werden, dass sie mindestens um einen Faktor 2 oder 3 oder 5 oder eine Grössenordnung verringert sind gegenüber einem unkompensierten Sensor.

Die genannten Merkmale können gemeinsam oder auch einzeln oder in beliebiger Kombination vorteilhaft sein.

Bezugszeichenliste

| | |
|---|---|
| 1 | elektrooptisch aktives Medium, elektrooptischer Kristall, BGO-Kristall |
| 2 | Abstandsmedium, Quarzglas |
| 3 | Elektrode |
| 3a | Feldsteuerungselektrode |
| 3b | Spannungszuführung |
| 4 | Elektrode |
| 4a | Feldsteuerungselektrode |
| 4b | Spannungszuführung |
| 5 | Licht, Lichtstrahl |
| 6a | optische Zuführungsfaser |
| 6b | optische Rückführungsfaser |
| 7a,7b | Kollimatorlinse |
| 8a,8b | Polarisator |
| 9 | $\lambda/4$-Element |
| 10 | Strahlteiler |
| 11 | Umlenkprisma |
| 12 | reflektierendes Prisma |
| 13 | Isolatorstab |
| 14 | Verbindungsstab |
| 15 | Silikon |
| 16 | Lamellen (Beschirmung) |
| 17 | Koronaring |

| | |
|---|---|
| $d_1$ | effektive Dicke des elektrooptisch aktiven Mediums |
| $d_2$ | effektive Dicke des Abstandsmediums |
| E | elektrisches Feld, Feldlinie |
| $k_1$ | massgeblicher elektrooptischer Koeffizient des elektrooptischen Mediums |
| $k_2$ | massgeblicher elektrooptischer Koeffizient des Abstandsmediums |
| L | effektiver Elektrodenabstand |
| T | Temperatur |
| V | zu messende elektrische Spannung |
| $V_\pi$ | Halbwellenspannung |

| | |
|---|---|
| $\alpha$ | thermischer Ausdehnungskoeffizient |
| $\delta_1$ | effektive Dicke eines Elementes des elektrooptisch aktiven Mediums |
| $\delta_2,\delta_2'$ | effektive Dicke eines Elementes des Abstandsmediums |
| $\varepsilon_1$ | Dielektrizitätskonstante des elektrooptisch aktiven Mediums |
| $\varepsilon_2$ | Dielektrizitätskonstante des Abstandsmediums |
| $\Gamma,\Gamma^*$ | Phasenverschiebung |

**Patentansprüche**

1. Elektrooptischer Spannungssensor zur Messung einer elektrischen Spannung V, wobei die Spannung V zwischen zwei Elektroden (3,4) des elektrooptischen Spannungssensors anliegt und ein elektrisches Feld erzeugt, wobei die Elektroden (3, 4) voneinander beabstandet angeordnet sind, und wobei zwischen den Elektroden (3, 4) ein elektrooptisch aktives Medium (1) angeordnet ist, in welches Licht (5) einstrahlbar ist, dessen Polarisationszustand in dem elektrooptisch aktiven Medium (1) durch das elektrische Feld beeinflussbar und nach Austritt aus dem elektrooptisch aktiven Medium (1) detektierbar ist, wobei aus dem detektierten Polarisationszustand die Spannung V bestimmbar ist, wobei zwischen den zwei Elektroden (3, 4) ein Abstandsmedium (2) angeordnet ist, wobei

   das elektrooptisch aktive Medium (1) mit einer effektiven Dicke $d_1$ und das Abstandsmedium (2) mit effektiven Dicke $d_2$ zwischen den zwei Elektroden (3, 4) angeordnet sind,

   zwischen den Elektroden (3,4) ein Stapel von N Elementen des elektrooptisch aktiven Mediums (1) und N+1 Elementen des Abstandsmediums (2) angeordnet ist, wobei N eine ganze Zahl mit $N \geq 1$ ist, und wobei jeweils ein Element des elektrooptisch aktiven Mediums (1) zwischen zwei benachbarten Elementen des Abstandsmediums (2) angeordnet ist, wobei das erste und das letzte Element in dem Stapel mit je einer der zwei Elektroden (3,4) in Kontakt *ist,*

   wobei die effektiven Dicken $d_1$, $d_2$ mit der geometrischen Gesamtdicke der einzelnen Elemente des betreffenden Mediums (1, 2) übereinstimmen,

   das elektrooptisch aktive Medium (1) eine Dielektrizitätskonstante $\varepsilon_1$ und das Abstandsmedium (2) eine Dielektrizitätskonstante $\varepsilon_2$ für die Spannung V aufweisen, und

   die effektive Dicke $d_2$ des Abstandsmediums (2) und die effektive Dicke $d_1$ des elektrooptisch aktiven Mediums (1) derart gewählt sind, dass sich die Einflüsse der Temperaturabhängigkeiten der Dielektrizitätskonstanten $\varepsilon_1$ des elektrooptisch aktiven Mediums (1), der Dielektrizitätskonstanten $\varepsilon_2$ des Abstandsmediums (2), und

   - falls das Abstandsmedium (2) elektrooptisch nicht aktiv ist: des massgeblichen elektrooptischen Koeffizienten $k_1$ des elektrooptisch aktiven Mediums 1) oder,
   - falls sowohl das elektrooptisch aktive Medium (1) als auch das Abstandsmedium (2) elektrooptisch aktiv ist und von dem Licht (5) durchstrahlt wird: des massgeblichen elektrooptischen Koeffizienten $k_1$ des elektrooptisch aktiven Mediums (1) und des massgeblichen elektrooptischen Koeffizienten $k_2$ des Abstandsmediums (2) auf den detektierten Polarisationszustand des Lichtes (5) im wesentlichen gegenseitig aufheben,

   wobei die Temperaturabhängigkeit der detektierten Polarisationsänderung des Lichtes (5) null sein soll gemäss

   $$(\partial/\partial T) [k_1 \bullet E_1 \bullet d_1 + k_2 \bullet E_2 \bullet d_2] = 0$$

   wobei $E_1$ die elektrische Feldstärke in dem elektrooptisch aktiven Medium (1) und $E_2$ die elektrische Feldstärke in dem Abstandsmedium (1) ist und T = Temperatur und $\partial/\partial T$ = Temperaturableitung; und

   das Abstandsmedium (2) einen verschwindenden massgeblichen elektrooptischen Koeffizienten $k_2$ und/oder eine verschwindende Temperaturabhängigkeit $\partial k_2/\partial T$ seines massgeblichen elektrooptischen Koeffizienten $k_2$ aufweist.

2. Spannungssensor gemäss Anspruch 1, **dadurch gekennzeichnet, dass** gilt:

   $$(\partial k_1/\partial T) \bullet E_1 + k_1 \bullet (\partial E_1/\partial T) \approx 0 \, ,$$

   wobei das Abstandsmedium (2) elektrooptisch nicht aktiv ist;
   und insbesondere wobei die genannten elektrischen Feldstärken als

   $$E_1 \approx \varepsilon_2 \bullet V / (\varepsilon_2 \bullet d_1 + \varepsilon_1 \bullet d_2)$$

   und

$$E_2 \approx \varepsilon_1 \cdot V / (\varepsilon_2 \cdot d_1 + \varepsilon_1 \cdot d_2)$$

genähert sind.

**3.** Spannungssensor gemäss einem der vorangegangenen Ansprüche, **dadurch gekennzeichnet, dass** das Abstandsmedium (2) transparent und von festem Aggregatzustand ist, und dass sowohl das Abstandsmedium (2) als auch das elektrooptisch aktive Medium (1) von dem Licht durchstrahlt wird.

**4.** Spannungssensor gemäss einem der vorangegangenen Ansprüche, **dadurch gekennzeichnet, dass** das Abstandsmedium (2) eine vernachlässigbare Temperaturabhängigkeit $\partial\varepsilon_2/\partial T$ seiner Dielektrizitätskonstanten $\varepsilon_2$ aufweist.

**5.** Spannungssensor gemäss einem der vorangegangenen Ansprüche, **dadurch gekennzeichnet, dass** jedes der Elemente im wesentlichen zylinderförmig mit im wesentlichen demselben Zylinderdurchmesser ist.

**6.** Spannungssensor gemäss Anspruch 5, **dadurch gekennzeichnet, dass** die Elemente des elektrooptisch aktiven Mediums (1) alle dieselbe effektive Dicke $\delta_1 = d_1/N$ haben, und dass entweder

(a) die Elemente des Abstandsmediums (2) eine effektive Dicke $\delta_2 = d_2/N$ haben, wobei aber die äusseren zwei Elemente des Abstandsmediums (2) im Stapel eine effektive Dicke $\delta_2' = d2/(2 \cdot N)$ haben, oder dass
(b) die Elemente des Abstandsmediums (2) eine effektive Dicke $\delta_2 = d_2/(N+1)$ haben.

**7.** Spannungssensor gemäss einem der vorangegangenen Ansprüche, **dadurch gekennzeichnet, dass** die Elektroden (3,4) mitsamt dem elektrooptisch aktiven Medium (1) und dem Abstandsmedium (2) in Silikon (15) eingegossen sind.

**8.** Spannungssensor gemäss einem der vorangegangenen Ansprüche, **dadurch gekennzeichnet, dass** die Elektroden (3,4) mitsamt dem elektrooptisch aktiven Medium (1) und dem Abstandsmedium (2) in Silikon eingegossen sind, wobei das Silikon im Bereich der Elektroden (3,4), des elektrooptisch aktiven Mediums (1) und des Abstandsmediums (2) im wesentlichen zylinder- oder tonnenförmig ausgebildet ist mit einem Durchmesser, der zwischen 1.1- und 6-mal, insbesondere zwischen 2- und 4-mal, so gross ist wie eine maximale radiale Ausdehnung der Elektroden (3,4).

**9.** Spannungssensor gemäss Anspruch 7 oder 8, **dadurch gekennzeichnet, dass** das Silikon (15) im Bereich der Elektroden (3,4), des elektrooptisch aktiven Mediums (1) und des Abstandsmediums (2) im wesentlichen zylinder- oder tonnenförmig ausgebildet ist, und die Elektroden (3,4) elektrisch leitfähige Spannungszuführungen (3b,4b) aufweisen, die im wesentlichen stabförmig ausgebildet sind und ebenfalls in Silikon eingegossen sind, wobei das Silikon (15) im Bereich der Spannungszuführungen (3b,4b) im wesentlichen zylinderförmig ausgebildet ist und einen geringeren Durchmesser aufweist als im Bereich der Elektroden (3,4), des elektrooptisch aktiven Mediums (1) und des Abstandsmediums (2), und insbesondere dass das Silikon aussen eine Beschirmung aufweist.

**10.** Spannungssensor gemäss einem der vorangegangenen Ansprüche, **dadurch gekennzeichnet, dass** das elektrooptisch aktive Medium (1) kristallines BGO ist, das mit seiner [001]-Richtung parallel zur Ausbreitungsrichtung des Lichtes (5) orientiert ist, dass die Ausbreitungsrichtung des Lichtes (5) im wesentlichen entlang des durch die Spannung V erzeugten elektrischen Feldes verläuft, und dass das Abstandsmedium (2) Quarzglas ist.

**11.** Verfahren zur Messung einer elektrischen Spannung V, wobei die Spannung V zwischen zwei voneinander beabstandet angeordneten Elektroden (3, 4) des elektrooptischen Spannungssensors anliegt und ein elektrisches Feld erzeugt, wobei Licht (5) in ein zwischen den Elektroden (3, 4) angeordnetes elektrooptisch aktives Medium (1) eingestrahlt wird, wobei ein Polarisationszustand des Lichtes (5) in dem elektrooptisch aktiven Medium (1) durch das elektrische Feld beeinflusst wird und das Licht nach Austritt aus dem elektrooptisch aktiven Medium (1) detektiert wird und aus dem detektierten Polarisationszustand die Spannung V bestimmt wird, wobei zwischen den zwei Elektroden (3, 4) ein Abstandsmedium (2) angeordnet wird,
wobei
zwischen den zwei Elektroden (3, 4) das Abstandsmedium (2) und das aktive Medium (1) angeordnet werden,
zwischen den Elektroden (3,4) ein Stapel von N Elementen des elektrooptisch aktiven Mediums (1) und N+1 Elementen des Abstandsmediums (2) angeordnet ist, wobei N eine ganze Zahl mit N ≥ 1 ist, und wobei jeweils ein Element des elektrooptisch aktiven Mediums (1) zwischen zwei benachbarten Elementen des Abstandsmediums (2) angeordnet ist, wobei das erste und das letzte Element in dem Stapel mit je einer der zwei Elektroden (3, 4) in Kontakt ist,

wobei die effektiven Dicken $d_1$, $d_2$ mit der geometrischen Gesamtdicke der einzelnen Elemente des betreffenden Mediums (1, 2) übereinstimmen,

das elektrooptisch aktive Medium (1) eine Dielektrizitätskonstante $\varepsilon_1$ und das Abstandsmedium (2) eine Dielektrizitätskonstante $\varepsilon_2$ für die Spannung V aufweisen, und

die effektive Dicke $d_2$ des Abstandsmediums (2) und die effektive Dicke $d_1$ des elektrooptisch aktiven Mediums (1) derart gewählt werden, dass sich die Einflüsse der Temperaturabhängigkeiten der Dielektrizitätskonstanten $\varepsilon_1$ des elektrooptisch aktiven Mediums (1), der Dielektrizitätskonstanten $\varepsilon_2$ des Abstandsmediums (2) und,

- falls das Abstandsmedium (2) elektrooptisch nicht aktiv ist: des massgeblichen elektrooptischen Koeffizienten $k_1$ des elektrooptisch aktiven Mediums (1) oder
- falls sowohl das elektrooptisch aktive Medium (1) als auch das Abstandsmedium (2) elektrooptisch aktiv ist und von dem Licht (5) durchstrahlt wird: des massgeblichen elektrooptischen Koeffizienten $k_1$ des elektrooptisch aktiven Mediums (1) und des massgeblichen elektrooptischen Koeffizienten $k_2$ des Abstandsmediums (2)

auf den detektierten Polarisationszustand des Lichtes (5) im wesentlichen gegenseitig aufheben,

wobei die Temperaturabhängigkeit der detektierten Polarisationsänderung des Lichtes (5) null sein soll gemäss

$$(\partial/\partial T)\ [k_1 \bullet E_1 \bullet d_1 + k_2 \bullet E_2 \bullet d_2] = 0$$

wobei $E_1$ die elektrische Feldstärke in dem elektrooptisch aktiven Medium (1) und $E_2$ die elektrische Feldstärke in dem Abstandsmedium (1) ist und T = Temperatur und $\partial/\partial T$ = Temperaturableitung; und

das Abstandsmedium (2) derart gewählt wird, dass es einen verschwindenden massgeblichen elektrooptischen Koeffizienten $k_2$ und/oder eine verschwindende Temperaturabhängigkeit $\partial k_2/\partial T$ seines massgeblichen elektrooptischen Koeffizienten $k_2$ aufweist.

**12.** Verfahren gemäss Anspruch 11, **dadurch gekennzeichnet, dass** gilt:

$$(\partial k_1/\partial T) \bullet E_1 + k_1 \bullet (\partial E_1/\partial T) \approx 0 \ ,$$

wobei das Abstandsmedium (2) elektrooptisch nicht aktiv ist;
und insbesondere wobei die genannten elektrischen Feldstärken als

$$E_1 \approx \varepsilon_2 \bullet V\ /\ (\varepsilon_2 \bullet d_1 + \varepsilon_1 \bullet d_2)$$

und

$$E_2 \approx \varepsilon_1 \bullet V\ /\ (\varepsilon_2 \bullet d_1 + \varepsilon_1 \bullet d_2)$$

genähert sind.

## Claims

**1.** Electro-optical voltage sensor for measurement of an electrical voltage V, the voltage V being present between two electrodes (3, 4) of the electro-optical voltage sensor and generating an electric field, the electrodes (3, 4) being arranged in a manner spaced apart from one another, and an electro-optically active medium (1) being arranged between the electrodes (3, 4), into which medium light (5) can be radiated, it being possible to influence the state of polarization of said light in the electro-optically active medium (1) by means of the electric field and to detect it after emergence from the electro-optically active medium (1), it being possible to determine the voltage V from the detected state of polarization, a distance medium (2) being arranged between the two electrodes (3, 4), the electro-optically active medium (1) being arranged with an effective thickness $d_1$ and the distance medium (2) with an effective thickness $d_2$ between the two electrodes (3, 4),

a stack of N elements of the electro-optically active medium (1) and N+1 elements of the distance medium (2) being arranged between the electrodes (3, 4), N being an integer where $N \geq 1$, and an element of the electro-optically active medium (1) in each case being arranged between two adjacent elements of the distance medium (2), the first and the last element in the stack being in contact with a respective one of the two electrodes (3, 4),

the effective thicknesses $d_1$ and $d_2$ corresponding to the geometrical total thickness of the individual elements of the relevant medium (1, 2),

the electro-optically active medium (1) having a dielectric constant $\varepsilon_1$ and the distance medium (2) having a dielectric constant $\varepsilon_2$ for the voltage V, and

the effective thickness $d_2$ of the distance medium (2) and the effective thickness $d_1$ of the electro-optically active medium (1) being chosen in such a way that the influences of the temperature dependences of the dielectric constant $\varepsilon_1$ of the electro-optically active medium (1), of the dielectric constant $\varepsilon_2$ of the distance medium (2) and,

- if the distance medium (2) is not electro-optically active; of the critical electro-optical coefficient $k_1$ of the electro-optically active medium (1), or
- if both the electro-optically active medium (1) and the distance medium (2) are electro-optically active and light (5) is radiated through them: of the critical electro-optical coefficient $k_1$ of the electro-optically active medium (1) and of the critical electro-optical coefficient $k_2$ of the distance medium (2), on the detected state of polarization of the light (5) essentially cancel one another out,

the temperature dependence of the detected change in polarization of the light (5) being intended to be zero in accordance with

$$(\partial/\partial T)\ [k_1 \bullet E_1 \bullet d_1 + k_2 \bullet E_2 \bullet d_2] = 0$$

where $E_1$ is the electric field strength in the electro-optically active medium (1) and $E_2$ is the electric field strength in the distance medium (2) and T = temperature and $\partial/\partial T$ = temperature derivative; and

the distance medium (2) having a vanishing critical electro-optical coefficient $k_2$ and/or a vanishing temperature dependence $\partial k_2/\partial T$ of its critical electro-optical coefficient $k_2$.

**2.** Voltage sensor according to Claim 1, **characterized in that** the following holds true:

$$\left(\partial k_1 \ / \ \partial T\right) \cdot E_1 \ + \ k_1 \ \cdot \ \left(\partial E_1 \ / \ \partial T\right) \ \approx \ 0$$

the distance medium (2) not being electro-optically active;
and in particular where the aforementioned electric field strengths are approximated as

$$E_1 \ \approx \ \varepsilon_2 \cdot V / \left(\varepsilon_2 \cdot d_1 + \varepsilon_1 \cdot d_2\right)$$

and

$$E_2 \ \approx \ \varepsilon_1 \cdot V / \left(\varepsilon_2 \cdot d_1 + \varepsilon_1 \cdot d_2\right)$$

**3.** Voltage sensor according to one of the preceding claims, **characterized in that** the distance medium (2) is transparent and of a solid state of aggregation, and **in that** the light radiates through both the distance medium (2) and the electro-optically active medium (1).

4. Voltage sensor according to one of the preceding claims, **characterized in that** the distance medium (2) has a negligible temperature dependence $\partial\varepsilon_2/\partial T$ of its dielectric constant $\varepsilon_2$.

5. Voltage sensor according to one of the preceding claims, **characterized in that** each of the elements is essentially cylindrical with essentially the same cylinder diameter.

6. Voltage sensor according to Claim 5, **characterized in that** the elements of the electro-optically active medium (1) all have the same effective thickness $\delta_1 = d_1/N$, and **in that** either

   (a) the elements of the distance medium (2) have an effective thickness $\delta_2 = d_2/N$, but the outer two elements of the distance medium (2) in the stack have an effective thickness $\delta_2' = d_2/(2N)$, or **in that**
   (b) the elements of the distance medium (2) have an effective thickness $\delta_2 = d_2/(N+1)$.

7. Voltage sensor according to one of the preceding claims, **characterized in that** the electrodes (3, 4) together with the electro-optically active medium (1) and the distance medium (2) are cast in silicone (15).

8. Voltage sensor according to one of the preceding claims, **characterized in that** the electrodes (3, 4) together with the electro-optically active medium (1) and the distance medium (2) are cast in silicone, the silicone in the region of the electrodes (3, 4), of the electro-optically active medium (1) and of the distance medium (2) being formed essentially in cylindrical or barrel-shaped fashion with a diameter which is between 1.1 and 6 times, in particular between 2 and 4 times, as large as a maximum radial extent of the electrodes (3, 4).

9. Voltage sensor according to Claim 7 or 8, **characterized in that** the silicone (15) in the region of the electrodes (3, 4), of the electro-optically active medium (1) and of the distance medium (2), is formed essentially in cylindrical or barrel-shaped fashion, and the electrodes (3, 4) have electrically conductive voltage feeds (3b, 4b), which are formed essentially in rod-type fashion and are likewise cast in silicone, the silicone (15) in the region of the voltage feeds (3b, 4b) being formed essentially in cylindrical fashion and having a smaller diameter than in the region of the electrodes (3, 4), of the electro-optically active medium (1) and of the distance medium (2), and, in particular, **in that** the silicone has a shielding on the outside.

10. Voltage sensor according to one of the preceding claims, **characterized in that** the electro-optically active medium (1) is crystalline BGO which is oriented with its [001] direction parallel to the direction of propagation of the light (5), **in that** the direction of propagation of the light (5) essentially runs along the electric field generated by the voltage V, and **in that** the distance medium (2) is fused silica.

11. Method for measurement of an electrical voltage V, the voltage V being present between two electrodes (3, 4) of the electro-optical voltage sensor arranged in a manner spaced apart from one another and generating an electric field, light (5) being radiated into an electro-optically active medium (1) arranged between the electrodes (3, 4), a state of polarization of the light (5) being influenced in the electro-optically active medium (1) by means of the electric field and the light being detected after emergence from the electro-optically active medium (1) and the voltage V being determined from the detected state of polarization, a distance medium (2) being arranged between the two electrodes (3, 4),
   the distance medium (2) and the active medium (1) being arranged between the two electrodes (3, 4),
   a stack of N elements of the electro-optically active medium (1) and N+1 elements of the distance medium (2) being arranged between the electrodes (3, 4), N being an integer where $N \geq 1$, and an element of the electro-optically active medium (1) in each case being arranged between two adjacent elements of the distance medium (2), the first and the last element in the stack being in contact with a respective one of the two electrodes (3, 4),
   the effective thicknesses $d_1$ and $d_2$ corresponding to the geometrical total thickness of the individual elements of the relevant medium (1, 2),
   the electro-optically active medium (1) having a dielectric constant $\varepsilon_1$ and the distance medium (2) having a dielectric constant $\varepsilon_2$ for the voltage V, and
   the effective thickness $d_2$ of the distance medium (2) and the effective thickness $d_1$ of the electro-optically active medium (1) being chosen in such a way that the influences of the temperature dependences of the dielectric constant $\varepsilon_1$ of the electro-optically active medium (1), of the dielectric constant $\varepsilon_2$ of the distance medium (2) and,

   - if the distance medium (2) is not electro-optically active; of the critical electro-optical coefficient $k_1$ of the electro-

optically active medium (1), or
- if both the electro-optically active medium (1) and the distance medium (2) are electro-optically active and light (5) is radiated through them: of the critical electro-optical coefficient $k_1$ of the electro-optically active medium (1) and of the critical electro-optical coefficient $k_2$ of the distance medium (2), on the detected state of polarization of the light (5) essentially cancel one another out,

the temperature dependence of the detected change in polarization of the light (5) being intended to be zero in accordance with

$$(\partial/\partial T)\ [k_1 \bullet E_1 \bullet d_1 + k_2 \bullet E_2 \bullet d_2] = 0$$

where $E_1$ is the electric field strength in the electro-optically active medium (1) and $E_2$ is the electric field strength in the distance medium (2) and T = temperature and $\partial/\partial T$ = temperature derivative; and
the distance medium (2) being chosen in such a way that it has a vanishing critical electro-optical co-efficient $k_2$ and/or a vanishing temperature dependence $\partial k_2/\partial T$ of its critical electro-optical co-efficient $k_2$.

**12.** Method according to Claim 11, **characterized in that** the following holds true:

$$\left(\partial k_1 \ / \ \partial T\right) \cdot E_1 \ + \ k_1 \ \cdot \ \left(\partial E_1 \ / \ \partial T\right) \ \approx \ 0$$

the distance medium (2) not being electro-optically active;
and in particular where the aforementioned electric field strengths are approximated as

$$E_1 \ \approx \ \varepsilon_2 \cdot V / \ (\varepsilon_2 \cdot d_1 + \varepsilon_1 \cdot d_2)$$

and

$$E_2 \ \approx \ \varepsilon_1 \cdot V / \ (\varepsilon_2 \cdot d_1 + \varepsilon_1 \cdot d_2)$$

**Revendications**

**1.** Détecteur de tension électro-optique destiné à mesurer une tension électrique V, la tension V étant présente entre deux électrodes (3, 4) du détecteur de tension électro-optique et générant un champ électrique, les électrodes (3, 4) étant disposées espacées l'une de l'autre et entre les électrodes (3, 4) étant disposé un milieu électro-optiquement actif (1) dans lequel peut être injectée de la lumière (5) dont l'état de polarisation dans le milieu électro-optiquement actif (1) peut être influencé par le champ électrique et peut être détecté après la sortie hors du milieu électro-optiquement actif (1), la tension V pouvant être déterminée à partir de l'état de polarisation détecté, un milieu d'espacement (2) étant disposé entre les deux électrodes (3, 4),
le milieu électro-optiquement actif (1) ayant une épaisseur effective $d_1$ et le milieu d'espacement (2) ayant une épaisseur effective $d_2$ étant disposés entre les deux électrodes (3, 4),
une pile de N éléments du milieu électro-optiquement actif (1) et de N+1 éléments du milieu d'espacement (2) étant disposée entre les électrodes (3, 4), N étant un nombre entier tel que $N \geq 1$, et un élément du milieu électro-optiquement actif (1) étant à chaque fois disposé entre deux éléments voisins de l'élément d'espacement (2), le premier et le dernier élément dans la pile étant en contact à chaque fois avec l'une des deux électrodes (3, 4),
les épaisseurs effectives $d_1$, $d_2$ coïncidant avec l'épaisseur totale géométrique des éléments individuels du milieu concerné (1, 2),
le milieu électro-optiquement actif (1) possédant une constante diélectrique $\varepsilon_1$ et le milieu d'espacement (2) une constante diélectrique $\varepsilon_2$ pour la tension V, et l'épaisseur effective $d_2$ du milieu d'espacement (2) et l'épaisseur effective $d_1$ du milieu électro-optiquement actif (1) étant choisies de telle sorte que les influences des dépendances à la température de la constante diélectrique $\varepsilon_1$ du milieu électro-optiquement actif (1), de la constante diélectrique $\varepsilon_2$ du milieu d'espacement (2), et

- dans le cas où le milieu d'espacement (2) n'est pas électro-optiquement actif, du coefficient électro-optique prédominant $k_1$ du milieu électro-optiquement actif (1) ou
- dans le cas où à la fois le milieu électro-optiquement actif (1) et le milieu d'espacement (2) sont électro-optiquement actifs et traversés par la lumière (5), du coefficient électro-optique prédominant $k_1$ du milieu électro-optiquement actif (1) et du coefficient électro-optique prédominant $k_2$ du milieu d'espacement (2) sur l'état de polarisation détecté de la lumière (5) s'annulent sensiblement réciproquement,

la dépendance à la température du changement de polarisation détecté de la lumière (5) devant être nulle conformément à

$$(\partial/\partial T) \ [k_1.E_1.d_1 \ + \ k_2.E_2.d_2] \ = \ 0$$

où $E_1$ désigne l'intensité du champ électrique dans le milieu électro-optiquement actif (1) et $E_2$ l'intensité du champ électrique dans le milieu d'espacement (2), et T désigne la température et $\partial/\partial T$ la dérivée de la température ; et le milieu d'espacement (2) possédant un coefficient électro-optique prédominant $k_2$ infiniment petit et/ou une dépendance à la température $\partial k_2/\partial T$ infiniment petite de son coefficient électro-optique prédominant $k_2$.

2. Détecteur de tension selon la revendication 1, **caractérisé en ce que** l'équation suivante est vérifiée :

$$(\partial k_1/\partial T).E_1 \ + \ k_1.(\partial E_1/\partial T) \ \approx \ 0,$$

le milieu d'espacement (2) n'étant pas électro-optiquement actif ;
et notamment les intensités de champ électrique mentionnées étant définies approximativement sous la forme

$$E_1 \ \approx \ \varepsilon_2.V/(\varepsilon_2.d_1 \ + \ \varepsilon_1.d_2)$$

et

$$E_2 \ \approx \ \varepsilon_1.V/(\varepsilon_2.d_1 \ + \ \varepsilon_1.d_2).$$

3. Détecteur de tension selon l'une des revendications précédentes, **caractérisé en ce que** le milieu d'espacement (2) est transparent et dans un état de la matière solide, et **en ce que** le milieu d'espacement (2) ainsi que le milieu électro-optiquement actif (1) sont tous deux traversés par la lumière.

4. Détecteur de tension selon l'une des revendications précédentes, **caractérisé en ce que** le milieu d'espacement (2) possède une dépendance à la température $\partial \varepsilon_2/\partial T$ infiniment petite de ses constantes diélectriques $\varepsilon_2$.

5. Détecteur de tension selon l'une des revendications précédentes, **caractérisé en ce que** chacun des éléments est sensiblement de forme cylindrique avec un diamètre de cylindre sensiblement identique.

6. Détecteur de tension selon la revendication 5, **caractérisé en ce que** les éléments du milieu électro-optiquement actif (1) possèdent tous la même épaisseur effective $\delta_1 = d_1/N$, et que soit

(a) les éléments du milieu d'espacement (2) possèdent une épaisseur effective $\delta_1 = d_2/N$, les deux éléments les plus à l'extérieur du milieu d'espacement (2) dans la pile possèdent cependant une épaisseur effective $\delta_2'= d_2/(2.N)$, ou soit
b) les éléments du milieu d'espacement (2) possèdent une épaisseur effective $\delta_2 = d_2/(N+1)$.

7. Détecteur de tension selon l'une des revendications précédentes, **caractérisé en ce que** les électrodes (3, 4), conjointement avec le milieu d'espacement (2) et le milieu électro-optiquement actif (1), sont enrobés dans du silicone (15).

8. Détecteur de tension selon l'une des revendications précédentes, **caractérisé en ce que** les électrodes (3, 4), conjointement avec le milieu d'espacement (2) et le milieu électro-optiquement actif (1), sont enrobés dans du silicone (15), le silicone dans la zone des électrodes (3, 4), du milieu électro-optiquement actif (1) et du milieu d'espacement (2) étant configuré sensiblement en forme de cylindre ou de tonneau avec un diamètre égal de 1,1 à 6 fois, notamment de 2 à 4 fois une expansion radiale maximale des électrodes (3, 4).

9. Détecteur de tension selon la revendication 7 ou 8, **caractérisé en ce que** le silicone (15) dans la zone des électrodes (3, 4), du milieu électro-optiquement actif (1) et du milieu d'espacement (2) est configuré sensiblement en forme de cylindre ou de tonneau, et les électrodes (3, 4) possèdent des arrivées de tension (3b, 4b) électriquement conductrices qui sont configurées sensiblement en forme de barres et qui sont également enrobées dans du silicone, le silicone (15) dans la zone des arrivées de tension (3b, 4b) étant de configuration sensiblement cylindrique et possédant un diamètre plus petit que dans la zone des électrodes (3, 4), du milieu électro-optiquement actif (1) et du milieu d'espacement (2), et notamment **en ce que** le silicone possède un blindage à l'extérieur.

10. Détecteur de tension selon l'une des revendications précédentes, **caractérisé en ce que** le milieu électro-optiquement actif (1) est du BGO cristallin dont la direction [001] est orientée parallèlement à la direction de propagation de la lumière (5), **en ce que** la direction de propagation de la lumière (5) s'étend sensiblement le long du champ électrique généré par la tension V, et **en ce que** le milieu d'espacement (2) est du verre de quartz.

11. Procédé de mesure d'une tension électrique V, la tension V étant présente entre deux électrodes (3, 4) du détecteur de tension électro-optique disposées espacées l'une de l'autre et générant un champ électrique, de la lumière étant injectée dans un milieu électro-optiquement actif (1) disposé entre les électrodes (3, 4) étant disposé, l'état de polarisation de la lumière (5) dans le milieu électro-optiquement actif (1) étant influencé par le champ électrique et la lumière étant détectée après la sortie hors du milieu électro-optiquement actif (1), et la tension V étant déterminée à partir de l'état de polarisation détecté, un milieu d'espacement (2) étant disposé entre les deux électrodes (3, 4), le milieu d'espacement (2) et le milieu actif (1) étant disposés entre les deux électrodes (3, 4),
une pile de N éléments du milieu électro-optiquement actif (1) et de N+1 éléments du milieu d'espacement (2) étant disposée entre les électrodes (3, 4), N étant un nombre entier tel que $N \geq 1$, et un élément du milieu électro-optiquement actif (1) étant à chaque fois disposé entre deux éléments voisins de l'élément d'espacement (2), le premier et le dernier élément dans la pile étant en contact à chaque fois avec l'une des deux électrodes (3, 4),
les épaisseurs effectives $d_1$, $d_2$ coïncidant avec l'épaisseur totale géométrique des éléments individuels du milieu concerné (1, 2),
le milieu électro-optiquement actif (1) possédant une constante diélectrique $\varepsilon_1$ et le milieu d'espacement (2) une constante diélectrique $\varepsilon_2$ pour la tension V, et l'épaisseur effective $d_2$ du milieu d'espacement (2) et l'épaisseur effective $d_1$ du milieu électro-optiquement actif (1) étant choisies de telle sorte que les influences des dépendances à la température de la constante diélectrique $\varepsilon_1$ du milieu électro-optiquement actif (1), de la constante diélectrique $\varepsilon_2$ du milieu d'espacement (2), et

- dans le cas où le milieu d'espacement (2) n'est pas électro-optiquement actif, du coefficient électro-optique prédominant $k_1$ du milieu électro-optiquement actif (1) ou
- dans le cas où à la fois le milieu électro-optiquement actif (1) et le milieu d'espacement (2) sont électro-optiquement actifs et traversés par la lumière (5), du coefficient électro-optique prédominant $k_1$ du milieu électro-optiquement actif (1) et du coefficient électro-optique prédominant $k_2$ du milieu d'espacement (2) sur l'état de polarisation détecté de la lumière (5) s'annulent sensiblement réciproquement,

la dépendance à la température du changement de polarisation détecté de la lumière (5) devant être nulle conformément à

$$(\partial/\partial T)\ [k_1.E_1.d_1\ +\ k_2.E_2.d_2]\ =\ 0$$

où $E_1$ désigne l'intensité du champ électrique dans le milieu électro-optiquement actif (1) et $E_2$ l'intensité du champ électrique dans le milieu d'espacement (2), et T désigne la température et $\partial/\partial T$ la dérivée de la température ; et le milieu d'espacement (2) étant choisi de telle sorte qu'il possède un coefficient électro-optique prédominant $k_2$ infiniment petit et/ou une dépendance à la température $\partial k_2/\partial T$ infiniment petite de son coefficient électro-optique

prédominant $k_2$.

12. Procédé selon la revendication 11, **caractérisé en ce que** l'équation suivante est vérifiée :

$$(\partial k_1/\partial T).E_1 \;+\; k_1.(\partial E_1/\partial T) \;\approx\; 0,$$

le milieu d'espacement (2) n'étant pas électro-optiquement actif ;
et notamment les intensités de champ électrique mentionnées étant définies approximativement sous la forme

$$E_1 \;\approx\; \varepsilon_2.V/(\varepsilon_2.d_1 \;+\; \varepsilon_1.d_2)$$

et

$$E_2 \;\approx\; \varepsilon_1.V/(\varepsilon_2.d_1 \;+\; \varepsilon_1.d_2).$$

**Fig. 1**

**Fig. 4**

**Fig. 5**

**Fig. 6**

**Fig. 2**

**Fig. 3**

**Fig. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0682261 A2
- US 4269483 A
- US 6307666 B
- DE 19716477 A1
- US 4939447 A

**In der Beschreibung aufgeführte Nicht-Patentliteratur**

- **P.A. WILLIAMS et al.** *Applied Optics,* 1996, vol. 35, 3562-3569
- **G.A. MASSEY ; D.C. ERICKSON ; R.A. KADLEC.** *Applied Optics,* 1975, vol. 14, 2712-2719
- *Optics Letters,* 1989, vol. 14, 290